# EUROPÄISCHE PATENTSCHRIFT

(11) **EP 4 487 665 B1**
(45) Veröffentlichungstag und Bekanntmachung des Hinweises auf die Patenterteilung: **28.10.2026**
(21) Anmeldenummer: 23707068.5
(22) Anmeldetag: 23.02.2023
(51) Int. Cl.: H10N 30/073, C04B 35/01, H04R 17/00, B06B 1/06, F04B 43/04, G10K 9/122, H10N 30/097, H10N 30/20, H10N 30/85, H10N 30/853, C04B 35/26, C04B 37/00, C04B 37/02, H04R 31/00

(54) **PIEZOELEKTRISCHES BAUTEIL UND HERSTELLUNGSVERFAHREN**
PIEZOELECTRIC COMPONENT AND PRODUCTION PROCESS
COMPOSANT PIÉZOÉLECTRIQUE ET PROCÉDÉ DE PRODUCTION

(30) Priorität: 01.03.2022 DE 102022104838; 08.09.2022 DE 102022122840
(43) Veröffentlichungstag der Anmeldung: 08.01.2025
(60) Teilanmeldung: 25164417.5 / 4 550 998
(73) Patentinhaber: TDK Electronics AG, 81671 München (DE)
(72) Erfinder: LISCHKA, Matthias, 8530 Deutschlandsberg (AT); OROSEL, Denis, 8530 Deutschlandsberg (AT); KOINI, Markus, 8054 Seiersberg (AT); PUFF, Markus, 8010 Graz (AT); PICHLER, Johann, 8614 Breitenau am Hochlantsch (AT); LUCCHI, Martina, 8053 Graz (AT)
(74) Vertreter: Epping - Hermann - Fischer
(86) Internationale Anmeldenummer: PCT/EP2023/054539
(87) Internationale Veröffentlichungsnummer: WO 2023/165890

(56) Entgegenhaltungen:
- WO-A1-2020/229696
- JP-A- 2014 017 799
- US-A1- 2003 222 240
- MICHAEL LORENZ ET AL: "Multiferroic BaTiO-BiFeOcomposite thin films and multilayers: strain engineering and magnetoelectric coup", JOURNAL OF PHYSICS D: APPLIED PHYSICS, INSTITUTE OF PHYSICS PUBLISHING, BRISTOL, GB, vol. 47, no. 13, 11 March 2014 (2014-03-11), pages 135303, XP020259694, ISSN: 0022-3727, [retrieved on 20140311], DOI: 10.1088/0022-3727/47/13/135303

## Beschreibung

Die vorliegende Erfindung betrifft ein piezoelektrisches Bauteil, die Verwendung einer bleifreien Keramik in einem piezoelektrischen Bauteil und ein Herstellungsverfahren.

Verschiedene Anwendungen wie haptische Sensoren und Aktoren, akustische Sensoren und Aktoren, Ultraschallwandler oder Anwendungen zum "Energy Harvesting" nutzen den piezoelektrischen Effekt aus. Die hierfür benötigten Piezoelemente werden in der Regel aus Variationen des keramischen Materials Blei-Zirkonium-Titanat (PbᵤZrᵥTi_{w}Oₓ), auch PZT genannt, gefertigt, wie beispielsweise im deutschen Patentdokument DE 10 2009 030710 A1 beschrieben.

Aufgrund dessen Materialeigenschaften müssen die Piezoelemente jedoch physikalisch zwingend eine gewisse Mindestdicke aufweisen und aufwändig prozessiert werden (hohe Sintertemperaturen, hoher Materialeinsatz).

Zudem enthalten diese Elemente hohe Anteile des umweltschädlichen Schwermetalls Blei.

Bauelemente aus dem Stand der Technik mit keramischen Piezoschichten, auch solche ohne Blei, sind z.B. in den Druckschriften JP 2014 017799 A oder US 2003/222240 A1 offenbart. Als relevante Nicht-Patent-Literatur ist z.B. folgende die Veröffentlichung zu nennen: MICHAEL LORENZ ET AL: "Multiferroic BaTiO-BiFeO composite thin films and multilayers: strain engineering and magnetoelectric coupling", JOURNAL OF PHYSICS, D: APPLIED PHYSICS, INSTITUTE OF PHYSICS PUBLISHING, BRISTOL, GB, Bd. 47, Nr. 13, 11. März 2014 (2014-03-11), Seite 135303, XP020259694, ISSN: 0022-3727, DOI: 10.1088/0022-3727/47/13/135303.

Durch Verwendung alternativer Materialien wie piezoaktiver Kunststoffe oder bleifreier piezoelektrischer Keramiken können diese nachteiligen Eigenschaften kompensiert werden. Eine Aufgabe der vorliegenden Erfindung ist es daher ein alternatives piezoelektrisches Bauteil mit einer verbesserten piezoelektrischen Schicht bereitzustellen.

Erfindungsgemäß wird ein piezoelektrisches Bauteil gemäß den Ansprüchen und ein entsprechendes Herstellungsverfahren offenbart. Die Erfindung ist durch die Ansprüche definiert.

Ein piezoelektrisches Bauteil gemäß Anspruch 1 und ein Herstellungsverfahren gemäß Anspruch 34 werden bereitgestellt.

Die Koerzitivfeldstärke der piezoelektrischen Schicht kann hierbei jener Koerzitivfeldstärke des polykristallinen Keramikmaterials entsprechen.

Die piezoelektrische Schicht weist eine Schichtdicke von mindestens 40 oder optional mindestens 50 µm auf. Die piezoelektrische Schicht ist bevorzugt mittels eines Folienprozesses umfassend Folienziehen und eine anschließende Polung im elektrischen Feld hergestellt.

Neben piezoelektrischen Schichten mit Keramiken mit polykristalliner Struktur sind auch Ausführungsformen mit piezoelektrischen Schichten auf Kunststoffbasis oder Schichten in denen Keramik und Kunststoff kombiniert werden möglich. Durch das optionale Zusetzen eines piezoelektrischen Kunststoffes kann die Koerzitivfeldstärke der piezoelektrischen Schicht optional auf bis zu 125 kV/mm erhöht werden.

Für die erfindungsgemäße piezoelektrische Schicht eignen sich keine keramischen Dünnschichten, insbesondere keine keramischen Dünnschichten aufweisend eine Struktur ähnlich einer einkristallinen Struktur, die beispielsweise mittels eines Sol-Gel-Verfahrens oder mittels chemischer Dampfphasenabscheidung (beispielsweise CVD oder ADL Verfahren) hergestellt sind, da diese im Verbund mit dem Trägerelement keine ausreichende mechanische Stabilität für die unten genannten Anwendungsbeispiele aufweisen. Die Eigenschaften solcher keramischer Dünnschichten sind, insbesondere wenn sie eine Einkristall-ähnliche Struktur aufweisen, durch die auftretenden intrakristallinen Wechselwirkungen im Keramikmaterial, wie z.B. kovalente oder ionische Bindungen, dominiert. In der Regel sind diese gekennzeichnet durch hohe Koerzitivfeldstärken über 10 kV/mm, weisen aber auch innerhalb der keramischen Dünnschicht mechanische Verspannungen durch nicht epitaktisches Wachstum auf.

Insbesondere in Aktor- und Sensoranwendungen wird die piezoelektrische Schicht erheblichen Zug- oder Druckkräften ausgesetzt, welche die Materialeigenschaften einer keramischen Dünnschicht, insbesondere einer keramischen Dünnschicht mit einkristalliner Struktur, überschreiten. Insbesondere kann die keramische Dünnschicht entlang der mechanischen Verspannungen reißen und das Bauteil dadurch elektrisch und/oder mechanisch unbrauchbar werden.

Die vorliegende Erfindung betrifft daher vielmehr die Verbesserung von piezoelektrischen Schichten mit einer Keramik mit polykristalliner Struktur. Die Koerzitivfeldstärke der piezoelektrischen Schicht mit polykristalliner Struktur hängt vor allem von interkristallinen Wechselwirkungen im Kristallgitter ab. Bisher bekannte piezoelektrische Schichten mit einer Keramik mit polykristalliner Struktur weisen in der Regel Koerzitivfeldstärken bis 3 kV/mm auf. Durch die Kombination eines geeigneten Materials und einer geeigneten dünnen Struktur konnte die Koerzitivfeldstärke der piezoelektrischen Schicht gemäß der Erfindung maximiert werden. Gleichzeitig konnten die, im Vergleich zu den keramischen Dünnschichten, toleranten Eigenschaften einer polykristallinen keramischen Schicht gegenüber mechanischen Verspannungen erhalten werden.

Die Materialeigenschaften von piezoelektrischen Keramiken mit einkristalliner Struktur bzw. mit einer Struktur ähnlich einem Einkristall (Materialverhalten gleicht dem Verhalten eines Kristalles, dominiert von intrakristallinen Wechselwirkungen) und von piezoelektrischen Keramiken mit polykristalliner Struktur (dominiert von interkristallinen Wechselwirkungen) sind also signifikant unterschiedlich und nicht übertragbar.

Alternative Bauteile, die piezoelektrische Keramiken mit einkristallinen Strukturen betreffen sind beispielsweise aus der WO 2021 / 249844 A1 oder US 2015 / 0 054 870 A1 oder US 2006 / 0 119 229 A1 bekannt.

Während eines Folienprozesses zur Herstellung der piezoelektrischen Schicht wird in einem ersten Schritt ein Rohmaterial als Pulver bereitgestellt. Aus dem Pulver wird durch das Zuführen von Bindungsmitteln und Lösungsmitteln sowie anschließendem Vermengen, Folienziehen und Trocknen eine Grünfolie hergestellt. Aus der Folie können anschließend vereinzelte Grünteile ausgestanzt werden. Alternativ kann die gesamte Folie als Grünteil weiterverarbeitet werden. Das Grünteil wird anschließend thermisch prozessiert und in ein Keramikteil umgewandelt. Während des thermischen Prozessierens wird das Grünteil bevorzugt entkohlt und gesintert und anschließend abgekühlt.

In einem anschließenden extrinsischen Aktivierungsprozess werden Elektroden auf das Keramikteil aufgebracht, um das Keramikteil zu polen und so eine piezoelektrische Schicht mit anwendungsrelevanter piezoelektrischer Funktionalität herzustellen.

Die Polung wird z.B. an Luft oder in einem flüssigen/ gasförmigen Isolationsmedium bei Temperaturen bevorzugt zwischen Raumtemperatur und 120 °C und bei Polungsfeldstärken von beispielsweise 3,5 bis 5 kV/mm vorgenommen. Beispielhaft wird die Polung an Luft mit 90 °C und bei 3,5 kV/mm vorgenommen. Die Temperatur liegt beim Polen somit deutlich unter einer Curie-Temperatur der piezoelektrischen Schicht.

Die piezoelektrische Schicht kann anschließend auf ein Trägerelement aufgebracht werden. Ein so hergestellter Aktor/ Sensor oder Wandler kann im Betrieb beispielsweise in einem E-Feld bis zu 3 kV/mm und bei Temperaturen zwischen Raumtemperatur und 270 °C betrieben werden.

Die Anregung der piezoelektrischen Schicht kann insbesondere im Anlegen eines elektrischen Feldes an die piezoelektrische Schicht bestehen.

In diesem Fall verformt sich die piezoelektrische Schicht und mit ihr das daran mechanisch gekoppelte Trägerelement, das somit als mechanischer Aktor fungiert.

Wird das Trägerelement mechanisch verformt, z.B. durch mechanischen Druck oder Schallwellen, verformt sich auch die mechanisch daran gekoppelte piezoelektrische Schicht, sodass ein elektrisches Signal generiert wird. Das Bauteil fungiert dann als Sensor.

In beiden Fällen fungiert das Bauteil als Wandler zwischen mechanischer und elektrischer Energie.

In einer Ausführungsform können zwei verschiedene Elektroden auf Oberflächen der piezoelektrischen Schicht aufgebracht sein. Im Betrieb weisen die beiden Elektroden bei Anliegen einer Spannung verschiedene Polaritäten auf.

Mittels der Elektroden kann ein elektrisches Feld an die piezoelektrische Schicht angelegt werden bzw. ein elektrisches Signal, insbesondere eine elektrische Spannung, von der piezoelektrischen Schicht abgegriffen werden.

Das Anlegen eines elektrischen Felds an die piezoelektrische Schicht kann insbesondere zu einer mechanischen Verformung der Schicht führen. Andererseits kann ein abzugreifendes elektrisches Signal durch mechanische Krafteinwirkung auf die piezoelektrische Schicht erzeugt werden.

Vorteilhaft sind die zwei Elektroden scheibenförmig und auf gegenüberliegenden Oberflächen der piezoelektrischen Schicht aufgebracht. Insbesondere können die zwei Elektroden vollflächig aufgebracht sein, sodass ein elektrisches Feld angelegt bzw. abgegriffen werden kann, das sich über die gesamte Dicke der piezoelektrischen Schicht erstreckt. In einer Ausführungsform bedecken die Elektroden die gegenüberliegenden Oberflächen nicht vollständig, sondern es ist auf den Oberflächen ein Freirand, also ein Abschnitt frei von den Elektroden, um die Elektroden ausgeprägt.

Bevorzugt sind die piezoelektrische Schicht und mindestens eine der Elektroden kreisscheibenförmig. Der Radius der kreisscheibenförmigen piezoelektrischen Schicht und der der kreisscheibenförmigen Elektrode können hierbei gleich groß oder unterschiedlich groß sein. Bevorzugt ist der Radius der kreisscheibenförmigen Elektrode bis zu 500 µm kleiner als der Radius des kreisscheibenförmigen piezoelektrischen Elements.

In einer Ausführungsform erstreckt sich mindestens eine der Elektroden über die Seitenfläche und optional auch über die gegenüberliegende Oberfläche der piezoelektrischen Schicht, sodass die Elektrode auf beiden der gegenüberliegenden Oberflächen aufgebracht ist. Somit kann die Elektrode von beiden Seiten elektrisch angebunden werden. In einer Ausführungsform können beide Elektroden entsprechend ausgeführt sein. Die Elektroden dürfen aber nicht in direktem Kontakt zueinanderstehen.

Das Trägerelement, das als Membran ausgeführt sein kann, ist bevorzugt elektrisch leitfähig und umfasst ein elektrisch leitfähiges Material, beispielsweise ein Metall wie Messing, Aluminium, Titan, Kupfer oder einen Stahl, ein Kohlefasermaterial, etc. Alternativ kann das Trägerelement z.B. auch ein Kunststoffmaterial oder glasfaser-verstärkten Kunststoff (GFK) umfassen, das beispielsweise an der Oberfläche metallisiert ist oder das leitfähige Partikel enthält.

Bevorzugt ist die piezoelektrischen Schicht bzw. eine der Elektroden auf der Oberfläche der piezoelektrischen Schicht kraftschlüssig auf dem Trägerelement aufgebracht.

In einer Ausführungsform ist die piezoelektrische Schicht bzw. eine der Elektroden auf der Oberfläche der piezoelektrischen Schicht stoffschlüssig auf dem Trägerelement aufgebracht. Beispielsweise ist hierzu eine Verbindungschicht aus einem Klebematerial zwischen der piezoelektrischen Schicht und dem Trägerelement vorgesehen. Das Klebematerial kann hierbei elektrisch nicht-leitend, anisotrop leitend, also bevorzugt in einer Richtung zwischen Trägerelement und Elektrode leitend und senkrechet dazu nicht leitend, oder leitend sein.

In einer Ausführung sind die piezoelektrische Schicht und die darauf aufgebrachten Elektroden als kreisförmige oder elliptische Scheiben ausgebildet. Alternativ sind die piezoelektrische Schicht und die darauf aufgebrachten Elektroden als 3-, 4-, 5-, 6- oder n-Eck ausgebildet (n ist hier eine natürliche Zahl >6).

Bevorzugt umfasst das piezoelektrische Bauteil weiterhin ein Trägerelement, beispielsweise eine Membran, auf der die piezoelektrische Schicht aufgebracht sein kann. Die Membran kann wie die piezoelektrische Schicht kreisförmig ausgeführt sein oder auch eine andere Geometrie als die piezoelektrische Schicht aufweisen.

Das Trägerelement bzw. die Membran ist bevorzugt eine der Elektroden, die auf einer Oberfläche der piezoelektrischen Schicht aufgebracht sind. Das Trägerelement kann hierfür elektrisch leitende Eigenschaften aufweisen. Das Trägerelement und die piezoelektrische Schicht sind beispielsweise durch Löten, Schweißen, Kleben, bevorzugt mit einem elektrisch leitfähigen Kleber, oder durch gemeinsames Sintern stoffschlüssig verbunden.

Eine äußere elektrische Anregung, insbesondere die Applikation eines elektrischen Felds, beispielsweise über auf der Oberfläche der piezoelektrischen Schicht aufgebrachte Elektroden, führt beispielsweise zu einer Kontraktion bzw. Expansion der Schicht aufgrund des piezoelektrischen Effekts. Bevorzugt ist hierbei für eine überwiegende Anzahl der Anwendungen eine gerichtete Kontraktion oder Expansion in Richtung der Schichtdicke oder senkrecht dazu in Richtung einer Schichtebene. Grundsätzlich ist mit der hier vorgestellten Lösung aber auch eine Kontraktion oder Expansion in einer beliebigen anderen Richtung möglich, wobei dies maßgeblich durch die Geometrie der Schicht bestimmt wird.

Hierzu wird ein elektrisches Feld an die piezoelektrische Schicht angelegt, wodurch sich diese in ihrer Ausdehnung ändert. Beispielsweise wird hierzu eine elektrische Spannung an die auf zwei Oberflächen der Schicht aufgebrachten Elektroden angelegt.

Die durch die Änderung der Ausdehnung der piezoelektrischen Schicht auf ein Trägerelement, wie beispielsweise auf eine Membran, wirkende Kraft führt zu einem Biegemoment und bewirkt eine Bewegung senkrecht zur Grundfläche des Bauteils, welche für die gewünschten Anwendungen genutzt wird.

Insbesondere bewirkt das Anlegen eines elektrischen Feldes an die piezoelektrische Schicht, dass die piezoelektrische Schicht ihre Ausdehnung ändert. Bevorzugt ändert sich die Ausdehnung in der Schichtebene der piezoelektrischen Schicht.

Beispielsweise kann sich im Falle einer kreisförmigen piezoelektrischen Schichtebene der Durchmesser der piezoelektrischen Schicht ändern. Insbesondere ändert sich der Durchmesser der piezoelektrischen Schicht, wenn die kreisförmige piezoelektrische Schicht als Radialoszillator betrieben wird. Durch die Kopplung der piezoelektrischen Schicht mit dem Trägerelement ergibt sich dann eine Auslenkung des Verbunds aus piezoelektrischer Schicht und Trägerelement in einer Richtung senkrecht zur Schichtebene der piezoelektrischen Schicht. Das heißt, dass die Ausdehnung der auf dem Trägerelement aufgebrachten piezoelektrischen Schicht zu einem Biegemoment führt, das eine Auslenkung des Trägerelements einer Richtung senkrecht zur Schichtebene der piezoelektrischen Schicht bewirkt.

Eine maximale Auslenkung des Trägerelements mit einem Durchmesser D in einer Richtung z senkrecht zur Schichtebene hängt somit sowohl von Eigenschaften der piezoelektrischen Schicht, insbesondere der Dicke der piezoelektrischen Schicht tₚ, der piezoelektrischen Konstante d31, der Poisson-Zahl v als Kennzahl für die Querkontraktion und dem Elastizitätsmodul (E-Modul) Eₚ der piezoelektrischen Schicht sowie von Eigenschaften des Trägerelements, insbesondere der Dicke des Trägerelements t_{c} und dem E-Modul des Trägerelements E_{c} ab.

Insbesondere kann die maximale Auslenkung A*_{displacement}* in der z-Richtung durch die folgende Formel in guter Näherung bestimmt werden: ${A}_{displacement} \left(z\right) = \frac{{D}^{2}}{8} \frac{6 {E}_{p} {E}_{c} {t}_{p} {t}_{c} \left({t}_{p}+{t}_{c}\right) {d}_{31} E \left(1-v\right)}{{{E}_{p}}^{2} {{t}_{p}}^{4} + {{E}_{c}}^{2} {{t}_{c}}^{4} + 2 {E}_{p} {E}_{c} {t}_{p} {t}_{c} \left(2{{t}_{p}}^{2}+2{{t}_{c}}^{2}+3{t}_{p}{t}_{c}\right)}$

Insbesondere die form- und stoffschlüssige Verbindung von piezoelektrischer Schicht und Trägermaterial mittels z.B. Klebers ermöglicht die Betrachtung des Sensors/ Aktors / Wandlers etc. als Komposit.

Aufgrund des obengenannten analytischen Zusammenhangs und der daraus resultierenden Wechselwirkung der Einzelkomponenten miteinander, muss die geforderten elektromechanischen Eigenschaften durch Änderung, z.B. der Geometrie oder des Trägermaterials, angepasst werden. D.h. nicht alleine die Eigenschaften der Keramik, sondern z.B. auch die genannten Wechselwirkungen sind für das Arbeitsverhalten des Aktors /Sensors /Wandlers etc. verantwortlich.

Für eine Anwendung als Sensor gilt der zuvor für eine Anwendung als Aktor beschriebene Sachverhalt umgekehrt. Das heißt, dass durch ein mittels einer Krafteinwirkung entlang der Hochachse hervorgerufenes Biegemoment in der piezoelektrischen Schicht eine messbare elektrische Spannung erzeugt wird, welche entsprechend ausgelesen bzw. abgegriffen werden kann.

Damit das Bauteil aus piezoelektrischer Schicht und Trägerelement eine Auslenkung aus einer Ruhelage erreicht, befindet sich entsprechend der Erfindung die neutrale Phase des Bauelementverbundes innerhalb der piezoelektrischen Schicht. Als neutrale Phase wird hierbei jene gedachte Linie, die keinerlei Deformation erfährt, bezeichnet.

Dies wird insbesondere durch folgende Größen und Verhältnisse beeinflusst, die daher geeignet gewählt sein müssen: Dicke und Durchmesser der Schicht, Dicke und Durchmesser des Trägerelements, Verhältnis der Dicken von Schicht und Trägerelement, Verhältnis der Durchmesser von Schicht und Trägerelement, Mittelpunkt-Mittepunkt-Abstand von Schicht und Trägerelement, E-Modul von Schicht und Trägerelement, Poisson-Zahl von Schicht und Trägerelement, 3D-Geometrie von Schicht und Trägerelement, akustische Impedanz von Schicht und Trägerelement, Federkontante von Schicht und Trägerelement sowie Dicke und elastomechanische Eigenschaften einer Verbindungsschicht zwischen Trägerelement und piezoelektrischer Schicht.

Bei dem erfindungsgemäßen Bauteil handelt es sich bevorzugt um einen Radialoszillator.

Der Unterschied zwischen einem Radial- und einem Dickenoszillator besteht im Wesentlichen in den unterschiedlichen Abmessungs-Verhältnissen von Durchmesser zu Dicke.

Ein Verhältnis von Durchmesser/Dicke der piezoelektrischen Schicht eines Radialoszillators beträgt Durchmesser/Dicke > 10 oder gleich 10. Ein Verhältnis von Durchmesser/Dicke der piezoelektrischen Schicht eines Dickenoszillators beträgt Durchmesser/Dicke < 10.

In einem Radialoszillator ändert sich der Durchmesser der piezoelektrischen Schicht bezogen auf den Ursprungsdurchmesser bei einer angelegten elektrischen Spannung. Dies wird durch die piezoelektrische Konstante d31 dargestellt.

Um eine Bewegung in Richtung der Dicke der piezoelektrischen Schicht zu erzeugen, wird wie zuvor beschrieben ein Trägermaterial benötigt. Das Trägermaterial und das Bauteil aus piezoelektrischer Schicht und Trägermaterial werden z.B. hinsichtlich Ladungsgenerierung, Impedanz und/oder Auslenkung für die jeweilige Anwendung optimiert.

Das Verhalten von Dickenoszillatoren wird hingegen durch eine piezoelektrische Konstante d33 und die angelegte elektrische Spannung beschrieben. Hierbei wird die Keramik direkt in Richtung der Dicke gestaucht bzw. gestreckt. Dickenoszillatoren benötigen somit kein Trägermaterial und sind eigenständig einsetzbar. Ein Beispiel für einen Dickenoszillator wird beispielsweise in der EP 3 372 571 B1 angegeben.

Durch seine Eigenschaft als Komposit ist der Radialoszillator für einen größeren Anwendungsbereich einsetzbar.

Radialoszillatoren können, wie beschrieben, beispielsweise als Aktoren, Sensoren oder Wandler eingesetzt werden. Zusätzlich zur Lage der neutralen Phase werden durch die oben genannten Größen auch folgende Eigenschaften eines piezoelektrischen Bauteils beeinflusst: zulässige Ansteuerspannung, Resonanzfrequenzen, zulässige Druck- und Zugspannungen für die Keramik, Blockierkraft, Güte, Impedanz, Kapazität und Ladungsgenerierung, akustische Impedanz, Federeigenschaften, mechanische Dämpfung, der Wirkungsgrad der Wandlung "elektrisch - mechanisch", der Wirkungsgrad der Wandlung "mechanisch - elektrisch" sowie Auslenkung und Beschleunigung.

Insbesondere zeichnet sich die beschriebene piezoelektrische Schicht durch die genannte hohe Koerzitivfeldstärke aus, sodass bei ansonsten unveränderten Anforderungen die Dicke der piezoelektrischen Schicht im piezoelektrischen Bauteil verringert werden kann. So kann der Materialeinsatz im Produktionsprozess bei einer gleichen Funktionalität des Bauteils um ca. 30 Prozent reduziert werden. Dies führt zu geringeren Herstellungskosten und einem geringeren Rohstoffaufwand.

Somit eignet sich die beschriebene piezoelektrische Schicht bevorzugt zur Herstellung dünner piezoelektrischer Bauteile. Erfindungsgemäß ein polykristallines, piezoelektrisches Keramikmaterial mit einer Koerzitivfeldstärke von mindestens 1,8 kV/mm für die Ausbildung der piezoelektrischen Schicht verwendet. Die Koerzitivfeldstärke der piezoelektrischen Schicht kann hierbei der Koerzitivfeldstärke des polykristallinen, piezoelektrischen Keramikmaterials entsprechen. Die Koerzitivfeldstärke der piezoelektrischen Schicht kann durch Zusetzen eines piezoelektrischen Kunststoffes auf bis zu 125 kV/mm erhöht werden.

Weiterhin ist die Sintertemperatur zur Herstellung des beschriebenen polykristallinen piezoelektrischen Keramikmaterials aus einer Grünschicht gering, sodass deren Herstellung mit weniger Energieaufwand und somit kostengünstiger durchgeführt werden kann.

Die Sintertemperatur beträgt beispielsweise weniger als 1050 °C, bevorzugt weniger als 1030 °C. Die Sintertemperatur beträgt weiterhin bevorzugt mehr als 900 °C und insbesondere zwischen 900 °C und 1030 °C.

Die Sintertemperatur der piezoelektrischen Schicht kann hierbei der Sintertemperatur des polykristallinen piezoelektrischen Keramikmaterials entsprechen.

Somit eignet sich die Grünschicht besonders für das Aufbringen und anschließende gemeinsame Sintern mit Trägerelementen bzw. Membranen, die empfindlich gegenüber höheren Temperaturen sind.

Die beschriebene Grünschicht eignet sich weiterhin zur Ausbildung von Keramikfolien, sodass eine piezoelektrische Schicht mit einer gewünschten geringen Schichtdicke einfach durch Folientechnologie, also durch Stapeln und Verpressen vorgefertigter Folien, realisiert werden kann. Die piezoelektrische Schicht kann auch nur eine Folie, mit entsprechender Dicke, umfassen. Durch Verwendung einer einzigen dicken Folie kann auf das Stapeln und Verpressen verzichtet werden, wodurch sich der Herstellungsprozess vereinfacht. Auf spanende Verfahren wie Schleifen oder Läppen zum Erreichen eines Sollwertes für die Dicke kann im vorliegenden Fall verzichtet werden. Dies ermöglicht eine weitere Material- und Ressourceneinsparung im Herstellungsprozess und verringert die Anzahl der hierfür benötigten Arbeitsschritte.

In einer bevorzugten Ausführungsform beträgt der elektromechanische Kopplungsfaktor k31 des polykristallinen piezoelektrischen Keramikmaterials zwischen 0,2 und 0,3, bevorzugt zwischen 0,25 und 0,3, besonders bevorzugt 0,27. Der elektromechanische Kopplungsfaktor k31 der piezoelektrischen Schicht kann hierbei dem elektromechanischen Kopplungsfaktor k31 des polykristallinen piezoelektrischen Keramikmaterials entsprechen.

In einer weiteren bevorzugten Ausführungsform beträgt die Dichte des polykristallinen piezoelektrischen Keramikmaterials zwischen 7000 und 7500 kg/m3. Die Dichte der piezoelektrischen Schicht kann hierbei der Dichte des polykristallinen piezoelektrischen Keramikmaterials entsprechen.

In einer weiteren bevorzugten Ausführungsform beträgt die relative dielektrische Konstante in Polungsrichtung oder Permittivitätszahl εᵣ = ε33/ε0 des polykristallinen piezoelektrischen Keramikmaterials weniger als 1100, bevorzugt weniger als 1000, besonders bevorzugt zwischen 800 und 1100, bevorzugter zwischen 900 und 1000, bevorzugter zwischen 910 und 950. Die Permittivitätszahl εᵣ der piezoelektrischen Schicht kann hierbei der Permittivitätszahl εᵣ des polykristallinen piezoelektrischen Keramikmaterials entsprechen. Durch Zusetzen eines piezoelektrischen Kunststoffes kann die Permittivitätszahl εᵣ der piezoelektrischen Schicht auf bis zu 8 reduziert werden.

In einer weiteren bevorzugten Ausführungsform beträgt die piezoelektrische Konstante des polykristallinen piezoelektrischen Keramikmaterials d31 weniger als 100 pm/V, bevorzugt zwischen 50 und 100 pm/V, bevorzugt zwischen 70 und 90 pm/V. Die piezoelektrische Konstante d31 der piezoelektrischen Schicht kann hierbei der piezoelektrischen Konstante d31 des polykristallinen piezoelektrischen Keramikmaterials entsprechen. Die piezoelektrische Konstante einer piezoelektrischen Schicht aus einem piezoelektrischen Kunststoff wie PVDF (Polyvinylidenfluorid) beträgt in etwa 10 bis 12 pm/V. Durch Zusetzen eines piezoelektrischen Kunststoffes kann die piezoelektrische Konstante d31 der piezoelektrischen Schicht somit weiter vermindert werden.

In einer weiteren bevorzugten Ausführungsform beträgt die Curie-Temperatur des polykristallinen piezoelektrischen Keramikmaterials zwischen 400 und 500 °C. Die Curie-Temperatur der piezoelektrischen Schicht kann hierbei der Curie-Temperatur des polykristallinen piezoelektrischen Keramikmaterials entsprechen.

In einer weiteren bevorzugten Ausführungsform beträgt die mechanische Güte Qm des polykristallinen piezoelektrischen Keramikmaterials zwischen 50 und 100, bevorzugt zwischen 50 und 70, bevorzugter 60. Die mechanische Güte Qm der piezoelektrischen Schicht kann hierbei der mechanische Güte Qm des polykristallinen piezoelektrischen Keramikmaterials entsprechen.

In einer weiteren bevorzugten Ausführungsform weist das Trägerelement ein Elastizitätsmodul E zwischen 0,1 und 1000 GPa, bevorzugt zwischen 60 und 215 GPa, bevorzugter zwischen 100 und 180 GPa auf.

Ein Verhältnis zwischen dem Elastizitätsmodul des Trägerelements und dem Elastizitätsmodul der piezoelektrischen Schicht beträgt bevorzugt zwischen 0,0004 und 3000. So kann eine gewünschte mechanische Wechselwirkung zwischen dem Trägerelement und der piezoelektrischen Schicht erreicht werden. Eine Verformung des Trägerelements resultiert in einer entsprechenden Verformung der piezoelektrischen Schicht und umgekehrt.

Die piezoelektrische Schicht ist bevorzugt frei von inneren Strukturelementen wie z.B. Innenelektroden oder Metallisierungsschichten.

In einer bevorzugten Ausführungsform umfasst die piezoelektrische Schicht ein Keramikmaterial mit einer Zusammensetzung (BiₓFeO₃)₁₋ₐ(Ba_{y}TiO₃)ₐ, wobei 0,20 ≤ a ≤ 0,50; 0,90 ≤ x ≤ 1,10 und 0,90 ≤ y ≤ 1,01 gilt. Die piezoelektrische Schicht kann hierbei im Wesentlichen aus diesem Keramikmaterial ausgebildet sein oder aus diesem bestehen. Bevorzugt ist das Keramikmaterial hierbei als polykristalline piezoelektrische Keramik ausgebildet. Das Keramikmaterial oder die gesamte piezoelektrische Schicht oder das ganze piezoelektrische Bauteil sind bevorzugt bleifrei.

Als bleifrei wird hier und im Folgenden insbesondere ein Material bezeichnet, das entsprechend der Richtlinie zur Beschränkung gefährlicher Stoffe (Restriction of Hazardous Substances, RoHS) der EU von 2011 weniger als 0,1 Massenprozent Blei (Pb) enthält.

In bevorzugten Ausführungen der Erfindung wird unter bleifrei ein noch deutlich geringerer Bleigehalt oder gar kein Bleigehalt verstanden.

Der Einsatz des bleifreien Keramikmaterials in piezoelektrischen Bauteilen ermöglicht die Realisierung der Bauteile ohne Verwendung des umweltschädlichen und giftigen Schwermetalls Blei. Insbesondere können so auch neue Anwendungen beispielsweise in Consumer-Produkten und Medizintechnik-Produkten ermöglicht werden.

Weiterhin sind die Eigenschaften der beschriebenen piezoelektrischen Bauteile denen konventioneller piezoelektrischen Bauteile auf Basis von bleihaltigen PZT-Keramiken sehr ähnlich. Bei einer geeigneten Dimensionierung der piezoelektrischen Schicht der Elektroden und eines gekoppelten Trägerelements kann das beschriebene piezoelektrische Bauteil wie konventionelle piezoelektrische Bauteile verwendet werden.

Insbesondere zeichnet sich das beschriebene Keramikmaterial durch eine hohe Koerzitivfeldstärke aus, sodass bei ansonsten unveränderten Randbedingungen die Dicke der piezoelektrischen Schicht im piezoelektrischen Bauteil verringert werden kann. So kann der Materialeinsatz im Produktionsprozess bei einer gleichen Funktionalität des Bauteils um ca. 30 Prozent reduziert werden. Dies führt zu geringeren Herstellungskosten und einem geringeren Rohstoffaufwand.

Somit eignet sich das beschriebene polykristalline Keramikmaterial bevorzugt zur Herstellung dünner polykristalliner piezoelektrischer Schichten bzw. dünner polykristalliner piezoelektrischer Bauteile.

Weiterhin ist die Sintertemperatur des beschriebenen Keramikmaterials ohne Blei geringer als das konventioneller Keramiken mit Blei, sodass die Herstellung der Keramikschicht mit weniger Energieaufwand und somit kostengünstiger durchgeführt werden kann.

Da auch Bauteilvolumen und Masse gegenüber bleihaltigen Bauteilen verringert ist, sinkt, zusätzlich zu der geringeren Sintertemperatur, auch die im Sinterofen zu erhitzende Materialmenge, wodurch der Prozess wirtschaftlicher wird. So kann bei gleicher Raumausnutzung die Beladung des Sinterofens entweder erhöht werden oder es muss bei gleicher Beladung nur eine geringere Masse auf die erforderliche Sintertemperatur erwärmt werden.

In einer bevorzugten Ausführungsform gilt für die Zusammensetzung des Keramikmaterials 0,25 ≤ a ≤ 0,40; 0,99 ≤ x ≤ 1,05 und 0,95 ≤ y ≤ 1,005.

In einer weiteren bevorzugten Ausführungsform gilt für die Zusammensetzung des Keramikmaterials 0,28 ≤ a ≤ 0,36; 0,99 ≤ x ≤ 1,05 und 0,975 ≤ y ≤ 1,005.

Ein solches Keramikmaterial weist besonders bevorzugte Eigenschaften auf. Insbesondere weist das Keramikmaterial geeignete piezoelektrische Eigenschaften auf, um hiermit bleihaltige oder kunststoffhaltige Keramikschichten verschiedener, und insbesondere dünner piezoelektrischer Bauteile mit variablen Anwendungen ersetzen zu können.

Zu den hier betrachteten piezoelektrischen Eigenschaften zählen unter anderem die piezoelektrische Konstante, die relative dielektrische Konstante, der elektromechanische Kopplungsfaktor, die Koerzitivfeldstärke, die Curie-Temperatur und die Dichte des Keramikmaterials.

Insbesondere weist das bleifreie piezoelektrische Keramikmaterial aufgrund seiner Zusammensetzung bevorzugt eine piezoelektrische Konstante von mindestens 75 pm/V, eine relative dielektrische Konstante von mindestens 1000, einen elektromechanischen Kopplungsfaktor von mindestens 0,25; eine Koerzitivfeldstärke von 1,8 kV/mm oder mehr, eine Curie-Temperatur über 400 °C und eine Dichte über 7000 kg/m³ auf.

Gemäß einer Ausführungsform ist die piezoelektrische Schicht frei von Kunststoffen als weiterer Inhaltsstoff. Insbesondere besteht die piezoelektrische Schicht bevorzugt aus anorganischen Materialien, welche das Keramikmaterial umfassen.

Die piezoelektrische Schicht weist somit eine hohe Dichte, Stabilität und Festigkeit auf. Insbesondere weist die piezoelektrische Schicht diese Eigenschaften in höherem Maße auf, als eine piezoelektrische Kunststoffschicht.

Gemäß einer Ausführungsform enthält die piezoelektrische Schicht keine weiteren Inhaltsstoffe als die genannten. Bevorzugt besteht die piezoelektrische Schicht aus dem Keramikmaterial.

Eine solche piezoelektrische Schicht weist die zuvor genannten vorteilhaften Eigenschaften des Keramikmaterials auf und ist insbesondere frei von Blei.

Gemäß weiterer Ausführungsformen umfasst die piezoelektrische Schicht einen piezoelektrischen Kunststoff. Die piezoelektrische Schicht kann insbesondere einen piezoelektrischen Kunststoff und eine Keramik, bevorzugt eines der zuvor genannten Keramikmaterialien, umfassen.

Kunststoffbasierte Schichten weisen eine hohe Flexibilität und frequenzabhängige Deformation auf. Dem Einsatz von reinen piezoelektrischen Kunststoffen wie z.B. PVDF sind für Aktor-/ Sensor-/ Wandleranwendungen aufgrund der mechanischen und thermischen Stabilität jedoch Grenzen gesetzt.

Nachteilige Eigenschaften von Piezokeramiken und - Kunststoffen können durch eine Kombination als Verbundmaterial ausgeglichen werden. Beispielsweise können ein gesintertes piezokeramisches Pulver oder gesinterte vorgeformten Keramiken z.B. Drähte in eine Kunststoffmatrix zugesetzt werden. Die mechanischen, elektrischen und elektromechanischen Eigenschaften des Verbundmaterials sind somit im Rahmen der Eigenschaften der Einzelkomponenten bezogen auf das Mischungsverhältnis der Komponenten, also Kunststoff und Keramik, einstellbar.

Herstellbar sind piezoelektrische Schichten aus solchen Keramik-Kunststoff-Verbundmaterialien mittels Herstellungsverfahren wie etwa mittels Folienziehen oder Pressen.

Gemäß einer Ausführungsform der Erfindung beträgt die Schichtdicke der piezoelektrischen Schicht mindestens 40 oder optional mindestens 50 Mikrometer (µm).

Gemäß einer Ausführungsform beträgt die Schichtdicke der piezoelektrischen Schicht maximal 150 µm.

Bevorzugt beträgt die Schichtdicke der piezoelektrischen Schicht maximal 140 µm, bevorzugter maximal 130 µm.

Bei einer Anwendung als Ultraschallwandler beträgt die Dicke bevorzugt zwischen 70 und 130 µm. Bei einer haptischen Anwendung beträgt die Dicke bevorzugt maximal 105 µm.

Eine solche geringe Schichtdicke verringert den Materialaufwand und die Kosten des Herstellungsprozesses und ermöglicht neue Anwendungen des piezoelektrischen Bauteils. Gemäß einer Ausführungsform beträgt die Schichtdicke der zugehörigen Grünschicht vor dem Sintern mindestens 50 µm. Gemäß einer Ausführungsform beträgt die Schichtdicke der Grünschicht maximal 210 µm und bevorzugt zwischen 120 und 160 µm.

Für einen Prozess, in dem mehrere Grünfolien zur Grünschicht gestapelt und verpresst werden, beträgt die Dicke der einzelnen Grünfolien bevorzugt zwischen 30 und 130 µm, besonders bevorzugt 80 µm.

Insbesondere kann durch eine Ausführung der piezoelektrischen Schicht mit einer so geringen Schichtdicke ein dünnes piezoelektrisches Bauteil bereitgestellt werden, das frei von Blei ist. Das dünne Bauteil weist bei der Herstellung einen geringen Materialverbrauch und beim Einbau in die vorgesehene Anwendungsvorrichtung einen geringen Raumverbrauch auf. So können vorteilhaft miniaturisierte Sensoren und Aktoren beispielsweise für den Einsatz in Computergehäusen, Smartphones oder für automatisierte und automotive Anwendungen bereitgestellt werden.

Ein solches dünnes piezoelektrisches Bauteil umfasst genau eine piezoelektrische Schicht mit der beschriebenen Schichtdicke und darauf aufgebrachte Elektroden, die bevorzugt ebenfalls eine geringe Schichtdicke im MikrometerBereich aufweisen.

Das piezoelektrische Bauteil kann so konfiguriert sein, dass es in verschiedensten Anwendungen eingesetzt werden kann.

Bevorzugt kann das ganze piezoelektrische Bauteil bleifrei sein. Das heißt, dass das Bauteil auch außerhalb der piezoelektrischen Schicht, genauso wie innerhalb der piezoelektrischen Schicht, keine bleihaltigen Bestandteile enthält. Somit kann der Einsatz von Blei, das giftige und umweltgefährdende Eigenschaften aufweist, vermieden werden und gesetzliche Regelungen bezüglich der Vermeidung einer Verwendung von Blei eingehalten werden.

Bevorzugt umfasst das piezoelektrische Bauteil in einer Ausführungsform weiterhin ein Trägerelement, auf dem die piezoelektrische Schicht wie oben beschrieben aufgebracht ist. Das Trägerelement kann eine Membran sein. Das Trägerelement kann eine der auf einer Oberfläche der piezoelektrischen Schicht aufgebrachten Elektroden sein. Es ist beispielsweise möglich das Piezoelement mit einem leitfähigen Trägerelement auf einer Seite leitfähig zu verbinden (z.B. durch Kleben oder durch Löten). In diesem Fall ist das Trägerelement quasi auch die Elektrode. Zusätzlich kann das beschriebene Fügemittel zwischen Trägerelement und piezoelektrischer Schicht vorhanden sein.

In anderen Ausführungsformen kann das Piezoelement bereits eine Elektrode aufweisen (z.B. durch Aufsputtern einer Metallschicht). Diese Elektrode ist dann durch eine leitfähige Verbindung (analog zum vorigen Beispiel) mit dem leitfähigen Trägerelement verbunden.

Das Bauteil umfasst in einer Ausführung das Trägerelement und die piezoelektrische Schicht. Bevorzugt ist die piezoelektrische Schicht als ellipsenförmige oder kreisförmige Scheibe ausgeführt, die auf einem ebenfalls scheibenförmigen Trägerelement mit einer bevorzugt größeren Oberfläche aufgebracht ist.

Bevorzugt beträgt ein Verhältnis des Durchmessers der kreisförmigen piezoelektrischen Schicht zu dem Durchmesser des kreisförmigen Trägerelements zwischen 0,3 und 1,0, bevorzugter zwischen 0,55 und 0,73, bevorzugter zwischen 0,6 und 0,7, jeweils einschließlich der jeweiligen Grenzwerte, beträgt.

So kann die Wechselwirkung zwischen piezoelektrischer Schicht und Trägerelement je nach Anwendungsfall optimiert werden.

Alternativ kann die Form der Scheiben auch vieleckig anstatt rund sein. Die Abmessungen der Oberfläche des scheibenförmigen Trägerelements und der piezoelektrischen Schicht sind deutlich größer als deren Dicken.

Auf einer Oberfläche der piezoelektrischen Schicht, die von dem Trägerelement abgewandt ist, ist eine erste Elektrode als Dünnschicht aufgebracht. Das Trägerelement kann dann die zweite Elektrode darstellen. Alternativ kann zwischen der piezoelektrischen Schicht und dem Trägerelement eine zweite Elektrode als Dünnschicht vorgesehen sein. Zwischen der Elektrode und dem Trägerelement kann weiterhin eine dünne Schicht eines Verbindungsmaterials wie beispielsweise eines Klebers oder eines Lots vorgesehen sein. Alternativ kann es sich bei der Verbindungsschicht um eine metallische Schicht hergestellt per Transient Liquid Phase-Sinterung, per Silbersintern oder einem ähnlichen Verfahren handeln.

Die Abmessungen der einzelnen beschriebenen Schichten des Bauteils weisen in einer Ausführung die gleiche Größenordnung wie die Abmessungen der piezoelektrischen Schicht auf und liegen bevorzugt im Mikrometerbereich.

Das piezoelektrische Bauteil ist bevorzugt ein dünnes polykristallines Bauteil. Die Richtung, in der die einzelnen Schichten des Bauteils übereinander gestapelt sind, wird als Stapelrichtung bezeichnet. Die Dicke des Bauteils in der Stapelrichtung, umfassend die oben beschriebenen Schichten, liegt bevorzugt im Mikrometerbereich.

In einer bevorzugten Ausführungsform umfasst das piezoelektrische Bauteil genau eine piezoelektrische Schicht. Bevorzugt umfasst das piezoelektrische Bauteil genau einmal die oben beschriebene Schichtabfolge aus der ersten Elektrode, der piezoelektrischen Schicht und der zweiten Elektrode, bevorzugt in Form des Trägerelements, und optional einem Trägerelement. Das Bauteil umfasst bevorzugt keine weiteren Schichten. Das piezoelektrische Bauteil ist somit möglichst dünn ausgeführt.

Das piezoelektrische Bauteil kann in verschiedenen Ausführungen insbesondere als Bauteil zur Anwendung als haptischer Aktor, haptischer Sensor, Summer, Ultraschallwandler, Ultraschallsender oder Ultraschallempfänger, Mikropumpe für Fluide, Energy Harvester oder Teilchendetektor ausgestaltet sein. Beispiele für solche Ausführungen sind im Weiteren ausführlich beschrieben.

Insbesondere kann das piezoelektrische Bauteil in einer Ausführungsform zur Anwendung als haptischer Aktor ausgestaltet sein, der geeignet ist, aus einem an der piezoelektrischen Schicht anliegenden elektrischen Signal eine mechanische Verformung des Trägerelements zu erzeugen.

Durch eine geeignete Anpassung der Ansteuerelektronik unter Ausnutzung der erhöhten Koerzitivfeldstärke, insbesondere der erhöhten Koerzitivfeldstärke der bleifreien Keramik verglichen mit einer bleihaltigen Keramik, kann die Dicke der piezoelektrischen Schicht und des Bauteils reduziert werden, ohne dass die Qualität des haptischen Signals nachlässt.

Die Auslenkung eines piezoelektrischen Aktors mit einer dünnen piezoelektrischen Schicht, die eine hohe Koerzitivfeldstärke aufweist, gleicht bei entsprechender Ansteuerung der Auslenkung eines Aktors mit einer dickeren piezoelektrischen Schicht mit geringerer Koerzitivfeldstärke. Die Koerzitivfeldstärke der piezoelektrischen Schicht beträgt zwischen 1,5 und 10 kV/mm.

Insbesondere kann die piezoelektrische Schicht auf Grund ihrer hohen Koerzitivfeldstärke geeignet sein, um mit einer Gleichspannung von mindestens 50 Volt und einer Spitze-Spitze-Spannung von mindestens 700 Volt beaufschlagt zu werden.

Durch eine Erhöhung der Koerzitivfeldstärke der piezoelektrischen Schicht aus bleifreier Keramik verglichen mit einer bleihaltigen Keramik kann somit unter Einsparung von Material ein funktionell gleichwertiges und dünneres, also platzsparendes, Bauteil hergestellt werden.

Insbesondere kann das piezoelektrische Bauteil in einer weiteren Ausführungsform zur Anwendung als haptischer Sensor ausgestaltet sein, der geeignet ist, aus einer mechanischen Verformung des Trägerelements ein an der piezoelektrischen Schicht abgreifbares elektrisches Signal zu erzeugen. Das Bauteil kann auch zur Anwendung als haptischer Aktor und Sensor ausgeführt sein.

Durch eine geeignete Anpassung der Auswerteelektronik unter Ausnutzung der erhöhten Koerzitivfeldstärke, insbesondere der erhöhten Koerzitivfeldstärke der bleifreien Keramik, kann die Dicke der piezoelektrischen Schicht und des Bauteils reduziert werden, ohne dass die Qualität des gemessenen elektrischen Signals nachlässt.

Das elektrische Signal eines piezoelektrischen Sensors mit einer dünnen piezoelektrischen Schicht, die eine hohe Koerzitivfeldstärke aufweist, gleicht bei geeigneter Ansteuerung dem Signal eines Sensors mit einer dickeren piezoelektrischen Schicht mit geringerer Koerzitivfeldstärke.

Die Koerzitivfeldstärke der piezoelektrischen Schicht beträgt zwischen 1,5 und 10 kV/mm.

Durch eine Erhöhung der Koerzitivfeldstärke der piezoelektrischen Schicht kann somit unter Einsparung von Material ein funktionell gleichwertiges und dünneres, also platzsparendes, Bauteil hergestellt werden.

In einer weiteren Ausführungsform ist das piezoelektrische Bauteil zur Anwendung als Summer ausgestaltet.

Als Summer wird hierbei ein Aktor bezeichnet, der aus einem elektrischen Signal Schall erzeugt, also quasi ein Schallsender.

Im Wesentlichen handelt es sich bei dem Summer um einen haptischen Aktor, der sich in einer bestimmten Frequenz verformt, um Schallwellen im hörbaren Bereich zu erzeugen.

Als Mindestanforderung kann hierbei beispielsweise ein Schalldruck von mindestens 75 Dezibel in einem Abstand von 10 cm von der Außenseite der Membran des Summers definiert werden. Aufgrund der hohen Koerzitivfeldstärke der bleifreien piezoelektrischen Schicht genügt eine piezoelektrische Schicht mit geringer Dicke von maximal 120 µm, um bei geeigneter Ansteuerung den erforderlichen Schalldruck zu erzeugen. Bevorzugt beträgt die Dicke der Schicht zwischen 80 und 120 µm, bevorzugter maximal 105 µm, bevorzugter maximal 100 µm oder weniger als 100 µm.

Die Dicke der Membran beträgt dann bevorzugt zwischen 25 µm und 125µm.

Bevorzugt beträgt der Durchmesser der Schicht zwischen einschließlich 5 mm und einschließlich 14 mm**.**

Mit diesen Abmessungen kann der Summer zumindest einen Frequenzbereich von 2 kHz bis 8 kHz abdecken.

Durch eine Erhöhung der Koerzitivfeldstärke der piezoelektrischen Schicht kann somit unter Einsparung von Material ein funktionell gleichwertiges und dünneres, also platzsparendes, Bauteil hergestellt werden.

Die piezoelektrische Schicht ist insbesondere so ausgestaltet, dass der Summer bei einer Anregung mittels eines elektrischen Signals mit einer Spannung von bis zu 3 Volt und einer elektrischen Frequenz von 4 kHz den maximalen Schalldruck erreicht.

In einer weiteren Ausführungsform ist das piezoelektrische Bauteil zur Anwendung als Ultraschallwandler oder Ultraschallsender oder Ultraschallempfänger ausgestaltet.

Der Ultraschallwandler kann sowohl aus einem elektrischen Signal einen Ultraschall erzeugen (Ultraschallsender) als auch umgekehrt aus einem Ultraschall ein elektrisches Signal erzeugen (Ultraschallempfänger).

Im Wesentlichen handelt es sich bei dem Ultraschallwandler um einen haptischen Aktor bzw. Sensor, der sich mit einer bestimmten Frequenz verformt, um Schallwellen im Ultraschallbereich Bereich zu erzeugen bzw. zu detektieren. In der Regel wird ein solcher Ultraschallwandler zur Abstandsmessung eingesetzt. Weiterhin können die Ultraschallwandler auch für andere Anwendungen, z.B. zur Übertragung von Energie- und/oder Daten, insbesondere durch Metall, verwendet werden.

Als Mindestanforderung kann hier ein ausreichend hoher Schalldruck definiert werden, der dazu geeignet ist, Objekte einer Entfernung von bis zu 200 cm zu detektieren.

Aufgrund der hohen Koerzitivfeldstärke der bleifreien piezoelektrischen Schicht genügt eine piezoelektrische Schicht mit einer geringen Dicke zwischen 70 und 130 µm, um bei geeigneter Ansteuerung den erforderlichen Schalldruck zu erzeugen. Bevorzugt beträgt der Durchmesser der Schicht 5 mm bis 14 mm oder 5 bis 7 mm**.**

Beispielsweise weist die piezoelektrische Schicht bevorzugt die folgenden Eigenschaften auf. Bei einer angelegten Wechselspannung von 1 Volt und einer Frequenz von 1 kHz beträgt die Kapazität C der piezoelektrischen Schicht zwischen 0,9 und 1,0 nF. Der dielektrische Verlust δ beträgt zwischen 0,05 und 0,15, bevorzugt 0,10. Die Permittivität ε beträgt zwischen 800 und 900. Die piezoelektrische Konstante d33 beträgt zwischen 100 und 200 pC/N. Die effektive Kopplung k_{eff} beträgt zwischen 0,2 und 0,3.

Die Eigenfrequenz der piezoelektrischen Schicht liegt beispielsweise zwischen 450 und 550 kHz, bevorzugt bei 500 kHz.

Bei einer Wechselspannung von 0,1 Volt und bei Resonanzfrequenz der Keramik beträgt die Kapazität C beispielweise zwischen 0,5 und 0,7 nF. Die Permittivität ε beträgt dann zwischen 400 und 500.

In einer weiteren Ausführungsform ist das piezoelektrische Bauteil als Mikropumpe für Fluide ausgestaltet. In einer solchen Mikropumpe kommen mehrere haptische Aktoren zum Einsatz. Die haptischen Aktoren bilden die Deckel von Mikrokammern, welche Fluide aufnehmen können.

Durch die Verformung eines solchen haptischen Aktors kann Fluid aus einer Mikrokammer verdrängt werden, sodass eine Pumpwirkung erzeugt wird. Bei Einsatz der beschriebenen vorteilhaften Bauteile mit einer dünnen piezoelektrischen Schicht kann die Größe der Mikropumpe reduziert werden und der Materialaufwand bei der Herstellung der Mikromikropumpe optimiert werden.

In einer weiteren Ausführungsform ist das piezoelektrische Bauteil zur Anwendung als Teilchendetektor ausgestaltet.

Das piezoelektrische Bauteil ist dazu in einem Strömungskanal verbaut. Im Strömungskanal kann beispielsweise ein Gas, das Feststoffpartikel transportiert, gefördert werden.

Im Betriebszustand wird die piezoelektrische Schicht des Bauteils wird mit einer Frequenz im Ultraschallbereich zum Schwingen angeregt.

Stößt ein Feststoffpartikel auf eine Membran des piezoelektrischen Bauteils, verformt sich die daran gekoppelte piezoelektrische Schicht und bewirkt eine Änderung der Schwingungsfrequenz. Die Änderung der Schwingungsfrequenz hängt von der Größe und Anzahl der Teilchen ab, die somit durch eine Auswerteelektronik bestimmt werden können.

Bei Einsatz der beschriebenen vorteilhaften Bauteile mit einer dünnen piezoelektrischen Schicht kann die Größe des Teilchendetektors reduziert werden und der Materialaufwand bei der Herstellung des Teilchendetektors optimiert werden.

Das piezoelektrische Bauteil kann in den genannten Anwendungen ein konventionelles piezoelektrisches Bauteil, umfassend ein bleihaltiges und/oder ein kunststoffhaltiges piezoelektrisches Material, ersetzen, ohne dass Abstriche in der Funktionalität gemacht werden müssen.

Weiterhin wird ein Verfahren zur Herstellung eines piezoelektrischen Bauteils mit einer piezoelektrischen Schicht offenbart, das sämtliche Merkmale des zuvor beschriebenen Bauteils aufweisen kann.

Die im Folgenden beschriebenen Merkmale können umgekehrt auch für sämtliche zuvor genannten Ausführungsformen gelten.

Das Verfahren umfasst mehrere Schritte. Ein Schritt umfasst das Bereitstellen von Grünfolien. Bevorzugt werden die Grünfolien durch Folienziehen hergestellt. Dies ergibt sehr homogene, aber dünne Folien. Die einzelnen Folien weisen bevorzugt eine Dicke von maximal 80 µm auf.

Ein weiterer Schritt umfasst das Übereinanderstapeln der Grünfolien zu einer Grünschicht mit einer Schichtdicke von bevorzugt maximal 130 µm.

Alternativ kann auch gleich eine einzige dicke Grünfolie bereitgestellt werden. Diese wird per Foliengießen hergestellt. Aufgrund des Herstellungsverfahrens ist die Folie dann dicker aber inhomogener, mit zusätzlich längerer Trockenzeit und in der Regel auch größerem Sinterschwund.

Ein wiederum weiterer Schritt umfasst das Sintern der Grünschicht bei einer Temperatur von maximal 1030 °C, sodass die piezoelektrische Schicht erhalten wird.

Ein weiterer Schritt betrifft das Aufbringen der piezoelektrischen Schicht auf ein Trägerelement und das stoffschlüssige Verbinden mit dem Trägerelement, sodass die Schicht und das Trägerelement mechanisch gekoppelt sind. Das Verhältnis der Dicke piezoelektrischen Schicht zur Dicke des Trägerelements beträgt dann bevorzugt 0,127 bis 1,3. Bevorzugt werden die Schritte in der genannten Reihenfolge ausgeführt. Besonders bevorzugt folgen die Schritte unmittelbar aufeinander.

In einem Ausführungsbeispiel werden Grünfolien bereitgestellt, die ein Keramikmaterial mit der Zusammensetzung (BiₓFeO₃)₁₋ₐ(Ba_{y}TiO₃)ₐ, wobei 0,20 ≤ a ≤ 0,50; 0,90 ≤ x ≤ 1,10 und 0,90 ≤ y ≤ 1,01 gilt, umfassen.

Eine bevorzugte Schichtdicke beträgt zwischen 50 und 150 Mikrometer. Zwischen den einzelnen piezoelektrischen Folien sind bevorzugt keine weiteren Schichten vorgesehen, sodass die Grünfolien direkt übereinander liegen.

In einer Ausführungsform des Verfahrens, kann die Grünschicht vor dem Sintern auf ein Trägerelement aufgebracht werden und gemeinsam mit diesem gesintert werden. Aufgrund der niedrigen Sintertemperatur eignet sich dieses Verfahren auch für Trägerelementen, die nicht bei Temperaturen über 1030 °C bearbeitet werden dürfen.

Die Herstellung der Schicht durch die beschriebene Folientechnologie ermöglicht die Herstellung der Schicht mit einer gewünschten Schichtdicke. Auf spanende Verfahren kann verzichtet werden, sodass Material eingespart wird. Aufgrund der niedrigen Sintertemperatur kann das Verfahren energetisch optimiert werden.

In einer bevorzugten Ausführungsform des Verfahrens wird die Sintertemperatur für maximal 4 Stunden gehalten.

In einer weiteren bevorzugten Ausführungsform des Verfahrens beträgt die Sintertemperatur maximal 1000° C. Somit können beispielsweise der Energieaufwand und die Kosten des Verfahrens jeweils reduziert werden bzw. die Umweltverträglichkeit des Verfahrens erhöht werden.

In einer Ausführungsform des Verfahrens kann die Grünschicht vor dem Sintern auf ein Trägerelement aufgebracht werden und gemeinsam mit diesem gesintert werden. Aufgrund der niedrigen Sintertemperatur eignet sich dieses Verfahren auch für Trägerelementen, die nicht bei Temperaturen über 1000 °C bearbeitet werden dürfen.

In einer weiteren bevorzugten Ausführungsform des Verfahrens beträgt die Sintertemperatur mindestens 900° C.

In weiteren Verfahrensschritten können Elektroden auf die piezoelektrische Schicht aufgebracht werden, bevorzugt auf zwei gegenüberliegende Oberflächen der Schicht. Beispielsweise können die Elektroden aufgedruckt werden.

Die piezoelektrische Schicht kann in einer Ausführungsform auf ein Trägerelement, beispielsweise eine Membran, aufgebracht werden und mit dem Trägerelement mechanisch gekoppelt werden. Das Bauteil ist dann bevorzugt so ausgestaltet, dass sich das Trägerelement und die piezoelektrische Schicht bei einer Anregung gemeinsam verformen.

Die Anregung kann insbesondere im Anlegen eines elektrischen Feldes an die piezoelektrische Schicht bestehen.

Das Trägerelement kann eine der Elektroden darstellen. Das Trägerelement kann aber auch zusätzlich zu den Elektroden bereitgestellt werden. Insbesondere kann die piezoelektrische Schicht mit aufgebrachten Elektroden auf das Trägerelement aufgebracht werden.

Das Trägerelement und die piezoelektrischen Schicht können durch gemeinsames Sintern stoffschlüssig verbunden sein.

Die piezoelektrische Schicht kann mit dem Trägerelement auch beispielsweise durch eine Verbindungschicht stoffschlüssig verbunden sein. Die Verbindungschicht kann einen Kleber umfassen. Die Dicke der Verbindungschicht beträgt bevorzugt nicht mehr als 20 µm.

Die Erfindung betrifft weiterhin ein Verfahren zur Herstellung eines bleifreien piezoelektrischen Bauteils mit der zuvor beschriebenen piezoelektrischen Schicht, wobei die piezoelektrische Schicht auf ein Trägerelement aufgebracht und mit dem Trägerelement stoffschlüssig verbunden wird, sodass die Schicht und das Trägerelement mechanisch gekoppelt sind.

Insbesondere kann die Grünschicht vor dem Sintern auf ein Trägerelement aufgebracht und mit dem Trägerelement gesintert werden. Alle zuvor genannten Ausführungen und deren Merkmale mit ihren Vorteilen gelten für dieses Verfahren analog.

Aufgrund der niedrigen Sintertemperatur eignet sich dieses Verfahren insbesondere auch für Trägerelemente, die nicht bei hohen Temperaturen bearbeitet werden dürfen.

Im Folgenden werden Ausführungsbeispiele anhand von Figuren beschrieben. Die vorliegende Erfindung ist nicht auf die gezeigten Ausführungsbeispiele beschränkt.

Die Figuren zeigen:
Figur 1 Perspektivische Ansicht eines ersten Ausführungsbeispiels eines piezoelektrischen Bauteils.
Figur 2 Detailansicht des ersten Ausführungsbeispiels des piezoelektrischen Bauteils im Querschnitt.
Figur 3 Querschnittsansicht eines zweiten Ausführungsbeispiels eines piezoelektrischen Bauteils als haptisches Element.
Figur 4 Perspektivische Ansicht eines vierten Ausführungsbeispiels eines piezoelektrischen Bauteils als Summer bzw**.** Ultraschallwandlers.
Figur 5 Schematische Darstellung der Funktionsweise einer Mikropumpe für Fluide.

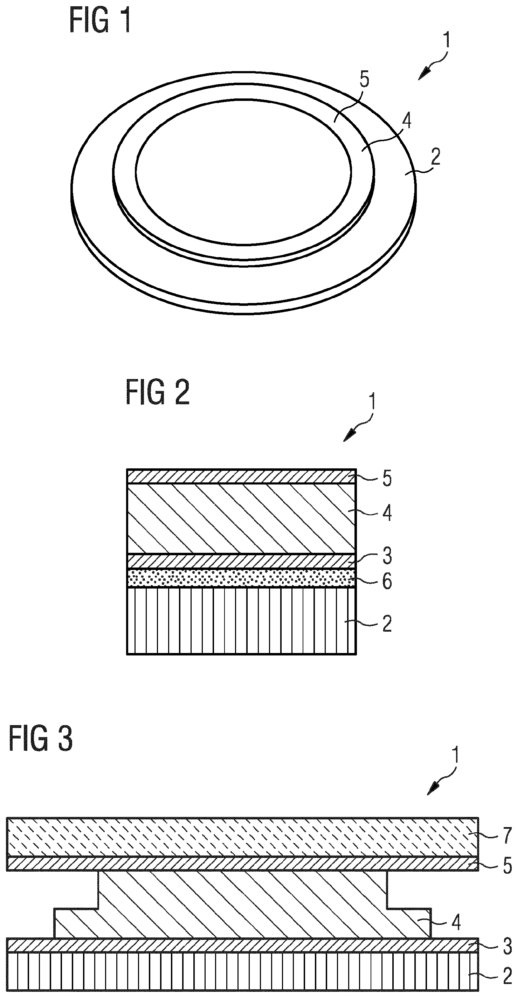

In den Figuren 1 und 2 ist ein erstes beispielhaftes piezoelektrisches Bauteil 1 gezeigt.

Auf einer Membran 2 als Trägerelement ist ein Piezoelement umfassend in dieser Reihenfolge eine erste Elektrode 3, eine piezoelektrischen Keramikschicht 4 und eine zweite Elektrode 5 aufgebracht. Das piezoelektrische Bauteil 1 und die Schichten, die es umfasst, sind im Ausführungsbeispiel als kreisrunde oder elliptisch geformte Scheiben ausgeführt.

Die Membran 2 ist bevorzugt elektrisch leitfähig und umfasst ein elektrisch leitfähiges Material, beispielsweise ein Metall wie Messing, Aluminium, Titan, Kupfer oder einen Stahl, ein Kohlefasermaterial, etc. Alternativ kann die Membran 2 ein Kunststoffmaterial umfassen, das an der Oberfläche metallisiert ist oder das leitfähige Partikel enthält.

Die Membran 2 sollte so beschaffen sein, dass sie sich in Abhängigkeit einer Verformung der Keramikschicht 4 verformt.

Die Membran 2 weist bevorzugt eine höhere Dicke und einen höheren Durchmesser als die Elektroden 3, 5 und die piezoelektrische Keramikschicht 4 auf.

Das Piezoelement ist beispielsweise über ein Verbindungsmaterial 6 wie einen Klebstoff auf der Membran 2 aufgebracht.

Die piezoelektrische Keramikschicht 3 ist bleifrei und umfasst ein Material mit der Zusammensetzung (BiₓFeO₃)₁₋ₐ(Ba_{y}TiO₃)ₐ. Die Indizes sind aus den Bereichen 0,28 ≤ a ≤ 0,36; 0,99 ≤ x ≤ 1,05 und 0,975 ≤ y ≤ 1,005 ausgewählt und betragen beispielsweise a = 0,305, x = 1,030, y = 0,995.

Die piezoelektrische Keramikschicht 4 ist so beschaffen und angeordnet, dass sie sich in Abhängigkeit einer Verformung der Membran 2 verformt.

Bevorzugt ist genau eine piezoelektrische Keramikschicht 4 im piezoelektrischen Bauteil 1 vorgesehen.

Im Vergleich zu herkömmlichen piezoelektrischen Keramikschichten weist die beschriebene bleifreie Keramikschicht 4 eine deutlich erhöhte Koerzitivfeldstärke auf. Im Beispiel beträgt die Koerzitivfeldstärke E_{c} = 1,9 kV/mm.

Aufgrund der erhöhten Koerzitivfeldstärke kann das piezoelektrische Bauteil 1 im Vergleich zu herkömmlichen Bauteilen mit einer deutlich geringeren Dicke der Keramikschicht 4 von beispielsweise 50 bis 110 Mikrometern ausgeführt werden.

Die Herstellung der vorliegenden Keramikschicht 4 ist somit materialsparender als die Herstellung herkömmlicher Keramikschichten.

Das beschriebene Keramikmaterial wird unter Luftatmosphäre gesintert. Aufgrund der vergleichsweise niedrigen Sintertemperatur und der vergleichsweise kurzen Haltezeit ist die Herstellung der beschriebenen Keramik energiesparender als die Herstellung herkömmlicher Keramikschichten.

Das beschriebene Keramikmaterial weist weiterhin eine vergleichsweise hohe Curie-Temperatur von 450 °C und eine ähnliche Dichte von 7,4 x10³ kg/m³ wie herkömmliche, nichtbleifreie piezoelektrische Materialien auf.

Das piezoelektrische Bauteil 1 kann als haptisches Element ausgeführt sein.

Das haptische Element kann in einem Ausführungsbeispiel als ein Aktor ausgeführt sein, das ein elektrisches Signal in eine mechanische Auslenkung der Membran 2 überträgt.

Hierzu wird ein elektrisches Feld an die piezoelektrische Keramikschicht 4 angelegt. Die piezoelektrische Schicht verformt sich in Reaktion auf das angelegte elektrische Feld. Die als kreisförmige Scheibe ausgeführte piezoelektrische Keramikschicht 4 wölbt sich insbesondere in ihrer Mitte aus der neutralen Position heraus. Als neutrale Position wird hierbei die Position der Keramikschicht 4**,** wenn kein elektrisches Feld angelegt ist, bezeichnet.

In einem weiteren Ausführungsbeispielen kann das haptische Element als ein Berührungssensor ausgeführt sein.

Hierzu kann beispielsweise wie in Figur 3 gezeigt eine zusätzliche Abdeckung 7 auf dem piezoelektrischen Element aufgebracht sein. Die Abdeckung 7 kann beispielsweise auf das piezoelektrische Element aufgeklebt sein.

Insbesondere kann der Berührungssensor in einem Trackpad beispielsweise eines Laptop-Computers verbaut sein. Das piezoelektrische Bauteil 1 ist dann direkt unter der berührungsempfindlichen Oberfläche des Trackpads angebracht.

Wird ein Druck auf die berührungsempfindliche Oberfläche des Trackpads ausgeübt, die in diesem Fall der Abdeckung 7 auf dem piezoelektrischen Element entsprechen kann, wird auch das darunter angeordnete piezoelektrische Element verformt. Als Reaktion auf die Verformung entsteht in der piezoelektrischen Schicht 4 eine elektrische Spannung, die als elektrisches Signal an eine Auswerteelektronik weitergeleitet wird.

Ähnliche Berührungssensoren sind beispielsweise auch hinter Bildschirmen von Mobiltelefonen angeordnet.

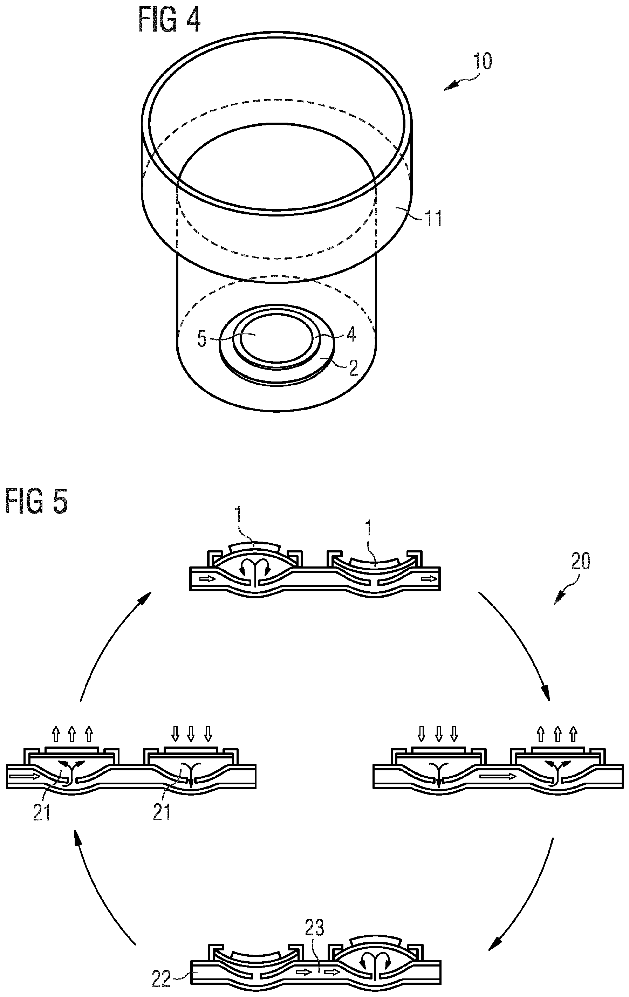

In einer weiteren Ausführungsform kann das piezoelektrische Bauteil 1 als Summer 10 ausgeführt sein, wie in Figur 4 gezeigt. Ein Summer 10 entspricht in seiner Funktionsweise im Wesentlichen einem haptischen Element. Durch das Anlegen einer geeigneten, entsprechend hohen elektrischen Frequenz, wird eine rasche und regelmäßige Verformung des piezoelektrischen Elements bewirkt und die daran gekoppelte Membran 2 somit zum Schwingen angeregt. Eine das piezoelektrische Bauteil 1 umgebende Resonanzkammer 11 ist zur Verstärkung des so erzeugten akustischen Signals vorgesehen.

Die Resonanzkammer 11 kann beispielsweise ein Aluminiumstopf sein, in dem das piezoelektrische Bauteil 1 eingeklebt ist.

Beispielsweise wird die piezoelektrischen Schicht 4 mit einer elektrischen Spannung von bis zu 3 Volt und einer elektrischen Frequenz von 4000 Hz beaufschlagt um ein akustisches Signal mit einer Lautstärke von mindestens 75 Dezibel zu erzeugen.

In einem weiteren Ausführungsbeispiel ist das piezoelektrische Bauteil 1 als Ultraschallwandler 10 ausgeführt. Ein Ultraschallwandler 10 ist im Wesentlichen ähnlich wie ein Summer 10 aufgebaut. Die erzeugte Schallfrequenz liegt im Unterschied zum Summer allerdings nicht im hörbaren Bereich, sondern im Ultraschallbereich.

Weiterhin fungiert das piezoelektrische Bauteil 1 als Ultraschallwandler 10 nicht nur als ein Aktor, der Ultraschall erzeugt, sondern ebenso als ein Sensor, der ein Ultraschallsignal detektiert. Insbesondere kann ein reflektiertes Ultraschallsignal des erzeugten und ausgesendeten Ultraschallsignals detektiert werden. Aus der Dauer zwischen dem Aussenden und dem Detektieren des reflektierten Ultraschallsignals, kann der Abstand zu einem reflektierenden Objekt bestimmt werden. Ein solcher Ultraschallwandler kann daher als ein Abstandssensor beispielsweise in automotiven Anwendungen eingesetzt werden.

In einem weiteren Ausführungsbeispiel, das in Figur 5 gezeigt ist, wird das piezoelektrische Bauteil 1 als Aktor einer Mikropumpe 20 für Fluide eingesetzt. Für den Aufbau der Pumpe sind mindestens zwei piezoelektrische Bauteile 1 notwendig. Die piezoelektrischen Bauteile 1 bilden hierbei die Abdeckungen miteinander verbundener Kammern 21. Die Kammern 21 sind beispielsweise durch eine Rohrleitung 22, die zur Förderung eines Fluides geeignet ist, verbunden. Ventile 23 in der Rohrleitung geben die Flussrichtung des Fluides zuvor. Durch die Verformung des piezoelektrischen Elements kann das Volumen der Kammern 21 vergrößert oder verkleinert werden, sodass ein Hub entsteht. Beispielsweise kann das Volumen einer ersten Kammer 21 verringert werden, während das Volumen einer zweiten, entlang der Rohrleitung folgenden Kammer 21 vergrößert wird, sodass das zu fördernde Fluid von der ersten zur zweiten Kammer 21 fließt.

Eine solche Mikropumpe 20 kann beispielsweise zur Dosierung von Fluiden im medizinischen Bereich eingesetzt werden.

In einem weiteren Ausführungsbeispiel wird das piezoelektrische Bauteil 1 als Synthetic Jet Actuator, also als Aktoren zur Erzeugung eines künstlichen Strahls, eingesetzt. Das Prinzip ist dasselbe wie für die Anwendung als Mikropumpe 20. Ein solcher Aktor kann beispielsweise zur gezielten Reinigung empfindlicher Oberflächen wie von Übertragungsflächen für optische und sensorische Oberflächen eingesetzt werden.

In einem weiteren Ausführungsbeispiel kann das piezoelektrische Bauteil 1 als ein Teilchendetektor eingesetzt werden. Das piezoelektrische Bauteil 1 ist dazu in einem Strömungskanal verbaut. Im Strömungskanal kann beispielsweise ein Gas, das Feststoffpartikel transportiert, gefördert werden.

Im Betriebszustand wird die piezoelektrische Schicht 4 des Bauteils wird mit einer Frequenz im Ultraschallbereich zum Schwingen angeregt.

Stößt ein Feststoffpartikel auf eine Membran 2 des piezoelektrischen Bauteils 1, verformt sich die daran gekoppelte piezoelektrische Schicht 4 und bewirkt eine Änderung der Schwingungsfrequenz. Die Änderung der Schwingungsfrequenz hängt von der Größe und Anzahl der Teilchen ab, die somit durch eine Auswerteelektronik bestimmt werden können.

In einem weiteren Ausführungsbeispiel dient das piezoelektrische Bauteil als Wandler von mechanischer Energie zu elektrischer Energie, also dem "Energy Harvesting". Diese Anwendung nutzt damit den umgekehrten Effekt als der haptische Aktor. Wird eine piezoelektrische Schicht 4 verformt, entsteht ein elektrisches Potential, welches durch eine geeignete Schaltung abgegriffen in Form von elektrischer Energie zwischengespeichert, als Messgröße ausgelesen oder direkt zum Versenden eines Signals verwendet werden kann.

Beispielhafte Applikationen hierfür sind drahtlose Sensoren für Lichtschalter, Tritt- oder Schließdetektoren, Vibrationsdetektoren oder Strömungsdetektoren.

In weiteren Ausführungsformen kann das beschriebene piezoelektrische Bauteil 1 zur Energie- und Datenübertragung durch Festkörper mittels Ultraschalltransmission eingesetzt werden. Anwendung findet diese Kommunikation zur Steuerung und zum Auslesen von Sensoren, Aktoren oder zur elektronischen Identifikation. Ein piezoelektrisches Bauteil 1 dient hierbei als Ultraschallsender und ein weiteres als Ultraschallempfänger.

In alternativen Ausführungsbeispielen kann die piezoelektrische Schicht 4 im Unterschied zu den zuvor beschrieben Beispielen auch einen piezoelektrischen Kunststoff wie z.B. PVDF (Polyvinylidenfluorid) umfassen. Die Schicht kann auch ein Keramikmaterial und einen Kunststoff umfassen.

### Bezugszeichen

- 1: piezoelektrisches Bauteil
- 2: Membran
- 3: Elektrode
- 4: piezoelektrische Schicht
- 5: Elektrode
- 6: Verbindungsmaterial
- 7: Abdeckung
- 10: Summer, Ultraschallwandler
- 11: Resonanzkammer
- 20: Mikropumpe
- 21: Kammer
- 22: Rohrleitung
- 23: Ventil

## Patentansprüche

1. Piezoelektrisches Bauteil (1) umfassend eine piezoelektrische Schicht (4), die ein polykristallines piezoelektrisches Keramikmaterial mit einer Koerzitivfeldstärke von mindestens 1,8 kV/mm aufweist und ein Trägerelement (2), auf das die piezoelektrische Schicht (4) aufgebracht ist und mit dem die piezoelektrische Schicht (4) mechanisch gekoppelt ist,
**dadurch gekennzeichnet, dass**
die Dicke der piezoelektrischen Schicht (4) mindestens 40 µm und ein Verhältnis der Dicke der piezoelektrischen Schicht (4) zu einer Dicke des Trägerelements (2) bevorzugt 0,127 bis 1,3 beträgt,
wobei sich eine neutrale Phase eines Bauelementverbundes aus Trägerelement (2) und piezoelektrischer Schicht (4) innerhalb der piezoelektrischen Schicht (4) befindet, wobei als neutrale Phase hierbei jene gedachte Linie bezeichnet wird, die keinerlei Deformation erfährt.

2. Piezoelektrisches Bauteil (1) nach Anspruch 1, wobei der elektromechanische Kopplungsfaktor k31 des polykristallinen piezoelektrischen Keramikmaterials 0,2 bis 0,3 beträgt.

3. Piezoelektrisches Bauteil (1) nach einem der Ansprüche 1 oder 2, wobei die Permittivitätszahl εᵣ des polykristallinen piezoelektrischen Keramikmaterials weniger als 1100 beträgt.

4. Piezoelektrisches Bauteil (1) nach Anspruch 3, wobei die die Permittivitätszahl εᵣ des polykristallinen piezoelektrischen Keramikmaterials zwischen 900 und 1000 und bevorzugt zwischen 910 und 950 beträgt.

5. Piezoelektrisches Bauteil (1) nach einem der Ansprüche 1 bis 4, wobei die piezoelektrische Konstante d31 des polykristallinen piezoelektrischen Keramikmaterials mindestens 50 pm/V und maximal 100 pm/V beträgt.

6. Piezoelektrisches Bauteil (1) nach einem der Ansprüche 1 bis 5, wobei die Curie-Temperatur des polykristallinen piezoelektrischen Keramikmaterials zwischen 400 und 500 °C beträgt.

7. Piezoelektrisches Bauteil (1) nach einem der Ansprüche 1 bis 6, wobei die mechanische Güte Qm des polykristallinen piezoelektrischen Keramikmaterials zwischen 50 und 100 beträgt.

8. Piezoelektrisches Bauteil (1) nach einem der Ansprüche 1 bis 7, wobei die Dichte des polykristallinen piezoelektrischen Keramikmaterials zwischen 7000 und 7500 kg/m3 beträgt.

9. Piezoelektrisches Bauteil (1) nach einem der Ansprüche 1 bis 8, wobei die Koerzitivfeldstärke, der elektromechanische Kopplungsfaktor k31, die Permittivitätszahl εᵣ, die piezoelektrische Konstante d31, die Curie-Temperatur, die mechanische Güte Qm, die Dichte der piezoelektrischen Schicht (4) oder mehrere der genannten Größen der entsprechenden Größe des polykristallinen piezoelektrischen Keramikmaterials entspricht.

10. Piezoelektrisches Bauteil (1) nach einem der Ansprüche 1 bis 9, wobei das Trägerelement (2) ein Elastizitätsmodul E zwischen 0,1 und 1000 GPa aufweist.

11. Piezoelektrisches Bauteil (1) nach einem der Ansprüche 1 bis 10, wobei die piezoelektrische Schicht (4) ein Keramikmaterial mit einer Zusammensetzung (BiₓFeO₃)₁₋ₐ(Ba_{y}TiO₃)ₐ umfasst, wobei 0,20 ≤ a ≤ 0,50 sowie 0,90 ≤ x ≤ 1,10 und 0,90 ≤ y ≤ 1,01 gilt.

12. Piezoelektrisches Bauteil (1) nach einem der Ansprüche 1 bis 11, wobei zwischen der piezoelektrischen Schicht (4) und dem Trägerelement (2) eine Elektrode als Dünnschicht vorgesehen ist.

13. Piezoelektrisches Bauteil (1) nach einem der Ansprüche 1 bis 12, wobei die piezoelektrische Schicht (4) und das Trägerelement (2) jeweils scheibenförmig sind und ein Verhältnis des Durchmessers der piezoelektrischen Schicht (4) zum Durchmesser des Trägerelements (2) bevorzugt 0,55 bis 0,73 beträgt.

14. Piezoelektrisches Bauteil (1) nach einem der Ansprüche 1 bis 13, wobei die piezoelektrische Schicht (4) keine Dünnschicht ist.

15. Piezoelektrisches Bauteil (1) nach einem der Ansprüche 1 bis 14, wobei das Bauteil (1) genau eine piezoelektrische Schicht (4) umfasst.

16. Piezoelektrisches Bauteil (1) nach einem der Ansprüche 1 bis 15, das zur Anwendung als haptischer Aktor ausgestaltet ist, der geeignet ist, aus einem an der piezoelektrischen Schicht (4) anliegenden elektrischen Signal eine mechanische Verformung des Trägerelements (2) zu erzeugen.

17. Piezoelektrisches Bauteil (1) nach Anspruch 16, wobei die piezoelektrische Schicht (4) zur Beaufschlagung mit einer Gleichspannung von mindestens 50 Volt und einer Spitze-Spitze-Spannung von mindestens 700 Volt geeignet ist.

18. Piezoelektrisches Bauteil (1) nach einem der Ansprüche 1 bis 17, das zur Anwendung als haptischer Sensor ausgestaltet ist, der geeignet ist, aus einer mechanischen Verformung des Trägerelements (2) ein an der piezoelektrischen Schicht (4) abgreifbares elektrisches Signal zu erzeugen.

19. Piezoelektrisches Bauteil (1) nach einem der Ansprüche 1 bis 15, das zur Anwendung als Summer (10) ausgestaltet ist, der geeignet ist, ein an der piezoelektrischen Schicht (4) anliegendes periodisches elektrisches Signal in eine mechanische Schwingung des Trägerelements (2) im hörbaren Schallbereich umzuwandeln.

20. Piezoelektrisches Bauteil (1) nach Anspruch 19, wobei die piezoelektrische Schicht (4) so ausgestaltet ist, dass der Summer (10) bei einer Anregung mittels eines elektrischen Signals mit einer Spannung von bis zu 3 Volt und einer elektrischen Frequenz von 4,0 x 10³ Hertz den maximalen Schalldruck erreicht.

21. Piezoelektrisches Bauteil (1) nach einem der Ansprüche 1 bis 15, das zur Anwendung als Ultraschallwandler (10) ausgestaltet ist, der geeignet ist, ein an der piezoelektrischen Schicht (4) anliegendes periodisches elektrisches Signal in eine mechanische Schwingung des Trägerelements (2) im Ultraschallbereich umzuwandeln und umgekehrt.

22. Piezoelektrisches Bauteil (1) nach einem der Ansprüche 1 bis 15, das zur Anwendung als Mikropumpe (20) für Fluide ausgestaltet ist.

23. Piezoelektrisches Bauteil (1) nach einem der Ansprüche 1 bis 15, das zur Anwendung als Teilchendetektor ausgestaltet ist.

24. Piezoelektrisches Bauteil (1) nach einem der Ansprüche 1 bis 23, wobei das Trägerelement (2) elektrisch leitende Eigenschaften aufweist und wobei das Trägerelement eine Elektrode (3) ist, die auf einer Oberfläche der piezoelektrischen Schicht (4) aufgebracht ist.

25. Piezoelektrisches Bauteil (1) nach einem der Ansprüche 1 bis 24, wobei das Trägerelement (2) durch Löten, Schweißen, Kleben mit einem Klebematerial oder durch gemeinsames Sintern stoffschlüssig mit der piezoelektrischen Schicht (4) verbunden ist.

26. Piezoelektrisches Bauteil (1) nach Anspruch 25, wobei das Klebematerial elektrisch nicht-leitend oder anisotrop leitend oder elektrisch leitend ist.

27. Piezoelektrisches Bauteil (1) nach einem der Ansprüche 1 bis 26, das ein Radialoszillator ist, wobei das Verhältnis von Durchmesser zu Dicke der piezoelektrischen Schicht (4) mindestens 10 oder mehr beträgt.

28. Piezoelektrisches Bauteil (1) nach einem der Ansprüche 1 bis 27, wobei die piezoelektrische Schicht (4) einen piezoelektrischen Kunststoff aufweist.

29. Piezoelektrisches Bauteil (1) nach Anspruch 28, wobei die piezoelektrische Schicht (4) Polyvinylidenfluorid aufweist.

30. Piezoelektrisches Bauteil (1) nach Anspruch 28 oder 29, wobei die piezoelektrische Schicht (4) ein Verbundmaterial aus einer piezoelektrischen Keramik und einem piezoelektrischen Kunststoff aufweist.

31. Piezoelektrisches Bauteil (1) nach einem der Ansprüche 28 bis 30, wobei die piezoelektrische Schicht (4) eine Koerzitivfeldstärke von bis zu 125 kV/mm aufweist.

32. Piezoelektrisches Bauteil (1) nach einem der Ansprüche 28 bis 31, wobei die piezoelektrische Schicht (4) eine Permittivitätszahl εᵣ größer als 8 aufweist.

33. Piezoelektrisches Bauteil (1) nach einem der Ansprüche 1 bis 32, wobei ein Verhältnis zwischen dem Elastizitätsmodul des Trägerelements (2) und dem Elastizitätsmodul der piezoelektrischen Schicht (4) zwischen 0,0004 und 3000 beträgt.

34. Verfahren zur Herstellung eines piezoelektrischen Bauteils (1) mit einer piezoelektrischen Schicht (4) umfassend die Schritte:
- Bereitstellen von mindestens einer Grünfolie zur Herstellung einer Grünschicht,
mit einer Schichtdicke von mindestens 50 µm und maximal 150 µm,
- Sintern der Grünschicht bei einer Temperatur von maximal 1050 °C, sodass die piezoelektrische Schicht (4) erhalten wird,
- Aufbringen der piezoelektrischen Schicht (4) auf ein Trägerelement (2) und stoffschlüssiges Verbinden mit dem Trägerelement (2), sodass die piezoelektrische Schicht (4) und das Trägerelement (2) mechanisch gekoppelt sind,
**dadurch gekennzeichnet, dass** die Dicke der piezoelektrischen Schicht (4) mindestens 40 µm und ein Verhältnis der Dicke der piezoelektrischen Schicht (4) zu einer Dicke des Trägerelements (2) bevorzugt 0,127 bis 1,3 beträgt,
wobei sich eine neutrale Phase eines Bauelementverbundes aus Trägerelement (2) und piezoelektrischer Schicht (4) innerhalb der piezoelektrischen Schicht (4) befindet, wobei als neutrale Phase hierbei jene gedachte Linie bezeichnet wird, die keinerlei Deformation erfährt.

35. Verfahren gemäß Anspruch 34, wobei die Sintertemperatur für maximal 4 Stunden gehalten wird.

36. Verfahren gemäß Anspruch 34 oder 35, wobei die Sintertemperatur maximal 1000° C und bevorzugt mindestens 900 °C beträgt.

37. Verfahren gemäß einem der Ansprüche 34 bis 36, wobei die Grünschicht vor dem Sintern auf ein Trägerelement (2) aufgebracht und mit dem Trägerelement (2) gesintert wird.

38. Verfahren gemäß einem der Ansprüche 34 bis 37, wobei zur Herstellung der Grünschicht mehrere Grünfolien übereinandergestapelt und verpresst werden.

39. Verfahren gemäß einem der Ansprüche 34 bis 37, wobei die Grünschicht genau eine Grünfolie umfasst.

40. Verfahren gemäß einem der Ansprüche 34 bis 39, wobei die gesinterte Schicht in einem externen elektrischen Feld gepolt wird, um die piezoelektrische Schicht (4) zu erhalten.

41. Verfahren gemäß einem der Ansprüche 34 bis 40, wobei das Trägerelement und die piezoelektrischen Schicht über eine Klebeschicht, eine Lötschicht oder eine metallische Schicht stoffschlüssig verbunden sind.

42. Verfahren gemäß Anspruch 41, wobei die Klebeschicht elektrisch nicht-leitend oder anisotrop leitend oder elektrisch leitend ist.

## Claims

1. Piezoelectric component (1) comprising a piezoelectric layer (4) comprising a polycrystalline piezoelectric ceramic material having a coercive field strength of at least 1.8 kV/mm, and a carrier element (2), to which the piezoelectric layer (4) is applied and to which the piezoelectric layer (4) is mechanically coupled,
**characterized in that** the thickness of the piezoelectric layer (4) is at least 40 µm and a ratio of the thickness of the piezoelectric layer (4) to a thickness of the carrier element (2) is preferably 0.127 to 1.3,
wherein a neutral phase of a component composite composed of carrier element (2) and piezoelectric layer (4) is located within the piezoelectric layer (4), wherein the neutral phase is designated here as that imaginary line which does not undergo any deformation at all.

2. Piezoelectric component (1) according to Claim 1, wherein the electromechanical coupling factor k31 of the polycrystalline piezoelectric ceramic material is 0.2 to 0.3.

3. Piezoelectric component (1) according to either of Claims 1 and 2, wherein the relative permittivity εᵣ of the polycrystalline piezoelectric ceramic material is less than 1100.

4. Piezoelectric component (1) according to Claim 3, wherein the relative permittivity εᵣ of the polycrystalline piezoelectric ceramic material is between 900 and 1000 and preferably between 910 and 950.

5. Piezoelectric component (1) according to any of Claims 1 to 4, wherein the piezoelectric constant d31 of the polycrystalline piezoelectric ceramic material is at least 50 pm/V and a maximum of 100 pm/V.

6. Piezoelectric component (1) according to any of Claims 1 to 5, wherein the Curie temperature of the polycrystalline piezoelectric ceramic material is between 400°C and 500°C.

7. Piezoelectric component (1) according to any of Claims 1 to 6, wherein the mechanical quality factor Qm of the polycrystalline piezoelectric ceramic material is between 50 and 100.

8. Piezoelectric component (1) according to any of Claims 1 to 7, wherein the density of the polycrystalline piezoelectric ceramic material is between 7000 and 7500 kg/m3.

9. Piezoelectric component (1) according to any of Claims 1 to 8, wherein the coercive field strength, the electromechanical coupling factor k31, the relative permittivity εᵣ, the piezoelectric constant d31, the Curie temperature, the mechanical quality factor Qm, the density of the piezoelectric layer (4) or a plurality of the aforementioned variables correspond(s) to the corresponding variable of the polycrystalline piezoelectric ceramic material.

10. Piezoelectric component (1) according to any of Claims 1 to 9, wherein the carrier element (2) has a modulus of elasticity E of between 0.1 and 1000 GPa.

11. Piezoelectric component (1) according to any of Claims 1 to 10, wherein the piezoelectric layer (4) comprises a ceramic material having a composition (BiₓFeO₃)₁₋ₐ(Ba_{y}TiO₃)ₐ, wherein 0.20 ≤ a ≤ 0.50 and 0.90 ≤ x ≤ 1.10 and 0.90 ≤ y ≤ 1.01 hold true.

12. Piezoelectric component (1) according to any of Claims 1 to 11, wherein an electrode is provided as a thin-film layer between the piezoelectric layer (4) and the carrier element (2).

13. Piezoelectric component (1) according to any of Claims 1 to 12, wherein the piezoelectric layer (4) and the carrier element (2) are each disc-shaped and a ratio of the diameter of the piezoelectric layer (4) to the diameter of the carrier element (2) is preferably 0.55 to 0.73.

14. Piezoelectric component (1) according to any of Claims 1 to 13, wherein the piezoelectric layer (4) is not a thin-film layer.

15. Piezoelectric component (1) according to any of Claims 1 to 14, wherein the component (1) comprises exactly one piezoelectric layer (4).

16. Piezoelectric component (1) according to any of Claims 1 to 15, which is configured for use as a haptic actuator suitable for generating a mechanical deformation of the carrier element (2) from an electrical signal applied to the piezoelectric layer (4).

17. Piezoelectric component (1) according to Claim 16, wherein the piezoelectric layer (4) is suitable for being subjected to a DC voltage of at least 50 volts and a peak-to-peak voltage of at least 700 volts.

18. Piezoelectric component (1) according to any of Claims 1 to 17, which is configured for use as a haptic sensor suitable for generating an electrical signal that can be tapped off at the piezoelectric layer (4) from a mechanical deformation of the carrier element (2).

19. Piezoelectric component (1) according to any of Claims 1 to 15, which is configured for use as a buzzer (10) suitable for converting a periodic electrical signal applied to the piezoelectric layer (4) into a mechanical vibration of the carrier element (2) in the audible sound range.

20. Piezoelectric component (1) according to Claim 19, wherein the piezoelectric layer (4) is configured such that the buzzer (10) reaches the maximum sound pressure upon an excitation by means of an electrical signal with a voltage of up to 3 volts and an electrical frequency of 4.0 x 10³ hertz.

21. Piezoelectric component (1) according to any of Claims 1 to 15, which is configured for use as an ultrasonic transducer (10) suitable for converting a periodic electrical signal applied to the piezoelectric layer (4) into a mechanical vibration of the carrier element (2) in the ultrasonic range, and vice versa.

22. Piezoelectric component (1) according to any of Claims 1 to 15, which is configured for use as a micropump (20) for fluids.

23. Piezoelectric component (1) according to any of Claims 1 to 15, which is configured for use as a particle detector.

24. Piezoelectric component (1) according to any of Claims 1 to 23, wherein the carrier element (2) has electrically conductive properties and wherein the carrier element is an electrode (3) applied on a surface of the piezoelectric layer (4).

25. Piezoelectric component (1) according to any of Claims 1 to 24, wherein the carrier element (2) is cohesively connected to the piezoelectric layer (4) by soldering, welding, adhesive bonding using an adhesive material or by joint sintering.

26. Piezoelectric component (1) according to Claim 25, wherein the adhesive material is electrically non-conductive or anisotropically conductive or electrically conductive.

27. Piezoelectric component (1) according to any of Claims 1 to 26, which is a radial oscillator, wherein the ratio of diameter to thickness of the piezoelectric layer (4) is at least 10 or more.

28. Piezoelectric component (1) according to any of Claims 1 to 27, wherein the piezoelectric layer (4) comprises a piezoelectric plastic.

29. Piezoelectric component (1) according to Claim 28, wherein the piezoelectric layer (4) comprises polyvinylidene fluoride.

30. Piezoelectric component (1) according to Claim 28 or 29, wherein the piezoelectric layer (4) comprises a composite material composed of a piezoelectric ceramic and a piezoelectric plastic.

31. Piezoelectric component (1) according to any of Claims 28 to 30, wherein the piezoelectric layer (4) has a coercive field strength of up to 125 kV/mm.

32. Piezoelectric component (1) according to any of Claims 28 to 31, wherein the piezoelectric layer (4) has a relative permittivity εᵣ of greater than 8.

33. Piezoelectric component (1) according to any of Claims 1 to 32, wherein a ratio between the modulus of elasticity of the carrier element (2) and the modulus of elasticity of the piezoelectric layer (4) is between 0.0004 and 3000.

34. Method for producing a piezoelectric component (1) having a piezoelectric layer (4), comprising the steps of:
- providing at least one green sheet for producing a green layer,
having a layer thickness of at least 50 µm and a maximum of 150 µm,
- sintering the green layer at a temperature of a maximum of 1050°C, so that the piezoelectric layer (4) is obtained,
- applying the piezoelectric layer (4) to a carrier element (2) and cohesively connecting it to the carrier element (2), so that the piezoelectric layer (4) and the carrier element (2) are mechanically coupled,
**characterized in that** the thickness of the piezoelectric layer (4) is at least 40 µm and a ratio of the thickness of the piezoelectric layer (4) to a thickness of the carrier element (2) is preferably 0.127 to 1.3,
wherein a neutral phase of a component composite composed of carrier element (2) and piezoelectric layer (4) is located within the piezoelectric layer (4), wherein the neutral phase is designated here as that imaginary line which does not undergo any deformation at all.

35. Method according to Claim 34, wherein the sintering temperature is maintained for a maximum of 4 hours.

36. Method according to Claim 34 or 35, wherein the sintering temperature is a maximum of 1000°C and preferably at least 900°C.

37. Method according to any of Claims 34 to 36, wherein the green layer is applied to a carrier element (2) before sintering, and sintered with the carrier element (2).

38. Method according to any of Claims 34 to 37, wherein a plurality of green sheets are stacked one above another and pressed in order to produce the green layer.

39. Method according to any of Claims 34 to 37, wherein the green layer comprises exactly one green sheet.

40. Method according to any of Claims 34 to 39, wherein the sintered layer is polarized in an external electric field in order to obtain the piezoelectric layer (4).

41. Method according to any of Claims 34 to 40, wherein the carrier element and the piezoelectric layer are cohesively connected via an adhesive layer, a solder layer or a metallic layer.

42. Method according to Claim 41, wherein the adhesive layer is electrically non-conductive or anisotropically conductive or electrically conductive.

## Revendications

1. Composant piézoélectrique (1) comportant une couche piézoélectrique (4) qui comprend un matériau céramique piézoélectrique polycristallin ayant une intensité du champ coercitif d'au moins 1,8 kV/mm et un élément de support (2) sur lequel la couche piézoélectrique (4) est appliquée et auquel la couche piézoélectrique (4) est mécaniquement couplée,
**caractérisé en ce que** l'épaisseur de la couche piézoélectrique (4) est d'au moins 40 µm et **en ce qu'**un rapport entre l'épaisseur de la couche piézoélectrique (4) et une épaisseur de l'élément de support (2) est de préférence de 0,127 à 1,3,
une phase neutre d'un ensemble composite constitué de l'élément de support (2) et de la couche piézoélectrique (4) se trouvant à l'intérieur de la couche piézoélectrique (4), la phase neutre désignant ici la ligne fictive qui ne subit aucune déformation.

2. Composant piézoélectrique (1) selon la revendication 1, dans lequel le facteur de couplage électromécanique k31 du matériau céramique piézoélectrique polycristallin est de 0,2 à 0,3.

3. Composant piézoélectrique (1) selon l'une des revendications 1 ou 2, dans lequel la permittivité relative εᵣ du matériau céramique piézoélectrique polycristallin est inférieure à 1100.

4. Composant piézoélectrique (1) selon la revendication 3, dans lequel la permittivité relative εᵣ du matériau céramique piézoélectrique polycristallin est comprise entre 900 et 1000 et de préférence entre 910 et 950.

5. Composant piézoélectrique (1) selon l'une des revendications 1 à 4, dans lequel la constante piézoélectrique d31 du matériau céramique piézoélectrique polycristallin est d'au moins 50 pm/V et d'au maximum 100 pm/V.

6. Composant piézoélectrique (1) selon l'une des revendications 1 à 5, dans lequel la température de Curie du matériau céramique piézoélectrique polycristallin est comprise entre 400 et 500 °C.

7. Composant piézoélectrique (1) selon l'une des revendications 1 à 6, dans lequel le facteur de qualité mécanique Qm du matériau céramique piézoélectrique polycristallin est compris entre 50 et 100.

8. Composant piézoélectrique (1) selon l'une des revendications 1 à 7, dans lequel la masse volumique du matériau céramique piézoélectrique polycristallin est comprise entre 7000 et 7500 kg/m3.

9. Composant piézoélectrique (1) selon l'une des revendications 1 à 8, dans lequel l'intensité du champ coercitif, le facteur de couplage électromécanique k31, la permittivité relative εᵣ, la constante piézoélectrique d31, la température de Curie, le facteur de qualité mécanique Qm, la masse volumique de la couche piézoélectrique (4) ou plusieurs desdites grandeurs correspondent à la grandeur correspondante du matériau céramique piézoélectrique polycristallin.

10. Composant piézoélectrique (1) selon l'une des revendications 1 à 9, dans lequel l'élément de support (2) présente un module d'élasticité E compris entre 0,1 et 1000 GPa.

11. Composant piézoélectrique (1) selon l'une des revendications 1 à 10, dans lequel la couche piézoélectrique (4) comprend un matériau céramique de composition (BiₓFeO₃)₁₋ₐ(Ba_{y}TiO₃)ₐ, où 0,20 ≤ a ≤ 0,50, 0,90 ≤ x ≤ 1,10 et 0,90 ≤ y ≤ 1,01.

12. Composant piézoélectrique (1) selon l'une des revendications 1 à 11, dans lequel il est prévu une électrode sous forme de couche mince entre la couche piézoélectrique (4) et l'élément de support (2).

13. Composant piézoélectrique (1) selon l'une des revendications 1 à 12, dans lequel la couche piézoélectrique (4) et l'élément de support (2) sont respectivement en forme de disque et un rapport entre le diamètre de la couche piézoélectrique (4) et le diamètre de l'élément de support (2) est de préférence de 0,55 à 0,73.

14. Composant piézoélectrique (1) selon l'une des revendications 1 à 13, dans lequel la couche piézoélectrique (4) n'est pas une couche mince.

15. Composant piézoélectrique (1) selon l'une des revendications 1 à 14, dans lequel le composant (1) comprend exactement une couche piézoélectrique (4).

16. Composant piézoélectrique (1) selon l'une des revendications 1 à 15, lequel est conçu pour être utilisé comme actionneur haptique apte à générer, à partir d'un signal électrique appliqué à la couche piézoélectrique (4), une déformation mécanique de l'élément de support (2).

17. Composant piézoélectrique (1) selon la revendication 16, dans lequel la couche piézoélectrique (4) est apte à être soumise à une tension continue d'au moins 50 volts et à une tension crête à crête d'au moins 700 volts.

18. Composant piézoélectrique (1) selon l'une des revendications 1 à 17, lequel est conçu pour être utilisé comme capteur haptique apte à générer, à partir d'une déformation mécanique de l'élément de support (2), un signal électrique pouvant être prélevé au niveau de la couche piézoélectrique (4).

19. Composant piézoélectrique (1) selon l'une des revendications 1 à 15, lequel est conçu pour être utilisé comme avertisseur sonore (10) apte à convertir un signal électrique périodique appliqué à la couche piézoélectrique (4) en une vibration mécanique de l'élément de support (2) dans le domaine acoustique audible.

20. Composant piézoélectrique (1) selon la revendication 19, dans lequel la couche piézoélectrique (4) est conçue de telle sorte que l'avertisseur sonore (10) atteigne la pression acoustique maximale lors d'une excitation au moyen d'un signal électrique ayant une tension allant jusqu'à 3 volts et une fréquence électrique de 4,0 x 10³ hertz.

21. Composant piézoélectrique (1) selon l'une des revendications 1 à 15, lequel est conçu pour être utilisé comme transducteur à ultrasons (10) apte à convertir un signal électrique périodique appliqué à la couche piézoélectrique (4) en une vibration mécanique de l'élément de support (2) dans le domaine des ultrasons et vice versa.

22. Composant piézoélectrique (1) selon l'une des revendications 1 à 15, lequel est conçu pour être utilisé comme micropompe (20) pour fluides.

23. Composant piézoélectrique (1) selon l'une des revendications 1 à 15, lequel est conçu pour être utilisé comme détecteur de particules.

24. Composant piézoélectrique (1) selon l'une des revendications 1 à 23, dans lequel l'élément de support (2) présente des propriétés de conduction électrique et dans lequel l'élément de support est une électrode (3) appliquée sur une surface de la couche piézoélectrique (4).

25. Composant piézoélectrique (1) selon l'une des revendications 1 à 24, dans lequel l'élément de support (2) est lié par complémentarité de matériau à la couche piézoélectrique (4) par brasage, soudage, collage au moyen d'un matériau adhésif ou par co-frittage.

26. Composant piézoélectrique (1) selon la revendication 25, dans lequel le matériau adhésif est électriquement non conducteur, à conduction anisotrope ou électriquement conducteur.

27. Composant piézoélectrique (1) selon l'une des revendications 1 à 26, lequel est un oscillateur radial, le rapport du diamètre à l'épaisseur de la couche piézoélectrique (4) étant d'au moins 10 ou plus.

28. Composant piézoélectrique (1) selon l'une des revendications 1 à 27, dans lequel la couche piézoélectrique (4) comprend une matière plastique piézoélectrique.

29. Composant piézoélectrique (1) selon la revendication 28, dans lequel la couche piézoélectrique (4) comprend du poly(fluorure de vinylidène).

30. Composant piézoélectrique (1) selon la revendication 28 ou 29, dans lequel la couche piézoélectrique (4) comprend un matériau composite constitué d'une céramique piézoélectrique et d'une matière plastique piézoélectrique.

31. Composant piézoélectrique (1) selon l'une des revendications 28 à 30, dans lequel la couche piézoélectrique (4) présente une intensité du champ coercitif allant jusqu'à 125 kV/mm.

32. Composant piézoélectrique (1) selon l'une des revendications 28 à 31, dans lequel la couche piézoélectrique (4) présente une permittivité relative εᵣ supérieure à 8.

33. Composant piézoélectrique (1) selon l'une des revendications 1 à 32, dans lequel un rapport entre le module d'élasticité de l'élément de support (2) et le module d'élasticité de la couche piézoélectrique (4) est compris entre 0,0004 et 3000.

34. Procédé de fabrication d'un composant piézoélectrique (1) comportant une couche piézoélectrique (4), comprenant les étapes suivantes :
- fourniture d'au moins une feuille verte pour la fabrication d'une couche verte,
présentant une épaisseur de couche d'au moins 50 µm et d'au maximum 150 µm,
- frittage de la couche verte à une température d'au maximum 1050 °C, de telle sorte que la couche piézoélectrique (4) soit obtenue,
- application de la couche piézoélectrique (4) sur un élément de support (2) et liaison par complémentarité de matériau à l'élément de support (2), de telle sorte que la couche piézoélectrique (4) et l'élément de support (2) soient couplés mécaniquement,
**caractérisé en ce que** l'épaisseur de la couche piézoélectrique (4) est d'au moins 40 µm et **en ce qu'**un rapport entre l'épaisseur de la couche piézoélectrique (4) et une épaisseur de l'élément de support (2) est de préférence de 0,127 à 1,3,
une phase neutre d'un ensemble composite constitué de l'élément de support (2) et de la couche piézoélectrique (4) se trouvant à l'intérieur de la couche piézoélectrique (4), la phase neutre désignant ici la ligne fictive qui ne subit aucune déformation.

35. Procédé selon la revendication 34, dans lequel la température de frittage est maintenue pendant au maximum 4 heures.

36. Procédé selon la revendication 34 ou 35, dans lequel la température de frittage est d'au maximum 1000 °C et de préférence d'au moins 900 °C.

37. Procédé selon l'une des revendications 34 à 36, dans lequel la couche verte est appliquée sur un élément de support (2) avant le frittage et est frittée avec l'élément de support (2).

38. Procédé selon l'une des revendications 34 à 37, dans lequel, pour la fabrication de la couche verte, plusieurs feuilles vertes sont empilées les unes sur les autres et pressées.

39. Procédé selon l'une des revendications 34 à 37, dans lequel la couche verte comprend exactement une feuille verte.

40. Procédé selon l'une des revendications 34 à 39, dans lequel la couche frittée est polarisée dans un champ électrique externe afin d'obtenir la couche piézoélectrique (4).

41. Procédé selon l'une des revendications 34 à 40, dans lequel l'élément de support et la couche piézoélectrique sont liés par complémentarité de matériau au moyen d'une couche adhésive, d'une couche de brasage ou d'une couche métallique.

42. Procédé selon la revendication 41, dans lequel la couche adhésive est électriquement non conductrice, à conduction anisotrope ou électriquement conductrice.
